# FASCICULE DE BREVET EUROPEEN

(11) **EP 4 513 757 B1**
(45) Date de publication et mention de la délivrance du brevet: **13.05.2026**
(21) Numéro de dépôt: 24193599.8
(22) Date de dépôt: 08.08.2024
(51) Int. Cl.: H03K 17/22, G06F 1/24

(54) **DISPOSITIF DE SURVEILLANCE D'UNE OU PLUSIEURS ALIMENTATIONS**
VORRICHTUNG ZUR ÜBERWACHUNG EINER ODER MEHRERER STROMVERSORGUNGEN
DEVICE FOR MONITORING ONE OR MORE POWER SUPPLIES

(30) Priorité: 18.08.2023 FR 2308779
(43) Date de publication de la demande: 26.02.2025
(73) Titulaire: Commissariat à l'Energie Atomique et aux Energies Alternatives, 75015 Paris (FR)
(72) Inventeur: SAMIR, Anass, 38054 GRENOBLE CEDEX 09 (FR); GIRAUD, Bastien, 38054 GRENOBLE CEDEX 09 (FR); RICAVY, Sébastien, 38025 GRENOBLE CEDEX 09 (FR)
(74) Mandataire: Cabinet Beaumont

(56) Documents cités:
- US-A1- 2006 208 777
- US-A1- 2010 244 805
- KHAN Q A ET AL: "A sequence independent power-on-reset circuit for multi-voltage systems", 2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA, 21 May 2006 (2006-05-21), pages 4pp, XP032457947, ISBN: 978-0-7803-9389-9, DOI: 10.1109/ISCAS.2006.1692824

## Description

### Domaine technique

La présente description concerne de façon générale la surveillance d'une ou plusieurs tensions d'alimentation, et, plus particulièrement, les stratégies de réinitialisation à la mise sous tension (POR de l'anglais "Power On Reset").

### Technique antérieure

Les puces connues comprennent de plus en plus souvent plusieurs domaines de tension d'alimentation et/ou des portions de la puce avec des circuits utilisant plusieurs tensions d'alimentation.

Lorsqu'une tension d'alimentation est éteinte, elle est dans un état haute impédance. Lorsqu'elle est allumée, ou mise sous tension, cette tension d'alimentation a d'abord une valeur nulle avant d'atteindre sa valeur nominale ou cible suite à une phase montée en puissance. Lors de la mise sous tension et de la montée en puissance d'une ou plusieurs tensions d'alimentations d'une portion de la puce, de nombreux problèmes se posent dans les circuits qui reçoivent cette ou ces tensions d'alimentation pour être alimentés. Un exemple d'un circuit de détection d'une tension d'alimentation est décrit dans la demande de brevet US 2010/0244805 A1.

Des circuits connus génèrent, lors de la montée en puissance d'une ou plusieurs tensions d'alimentation, un signal de réinitialisation qui permet de mettre les circuits à alimenter avec cette ou ces tensions d'alimentations dans un état initial connu. Des exemples de tels circuits sont, par exemple, décrits dans la demande de brevet US 2006/0208777 A1 et dans l'article "A Sequence Independant Power-on-Reset Circuit for Multi-Voltage Systems" de Khan et al.

Toutefois, ces circuits connus de réinitialisation à la mise sous tension présentent de nombreux inconvénients.

### Résumé de l'invention

Il existe un besoin d'un circuit de réinitialisation à la mise sous tension qui pallie tout ou partie des inconvénients des circuits connus de réinitialisation à la mise sous tension.

Par exemple, il existe un besoin pour un circuit de réinitialisation à la mise sous tension qui consomme moins que les circuits connus de réinitialisation à la mise sous tension.

Par exemple, il existe un besoin pour un dispositif de réinitialisation à la mise sous tension qui soit indépendant de la séquence de montée en puissance des tensions d'alimentation qu'il surveille.

Par exemple, il existe un besoin pour un dispositif de réinitialisation à la mise sous tension qui fournisse un signal de réinitialisation ayant un état défini dès que l'une des tensions d'alimentations surveillées par le dispositif est allumée et n'est plus dans un état haute impédance.

Par exemple, il existe un besoin pour un dispositif de réinitialisation à la mise sous tension qui permette une mise en œuvre avec des transistors MOS (de l'anglais "Metal Oxide Semiconductor" - métal oxyde semiconducteur) ayant une limite de tenue en tension Vmax alors que l'une des tensions alimentations surveillées par ce dispositif a une valeur nominale plus élevée que cette tenue en tension Vmax et/ou que la différence de valeurs entre deux des tensions surveillées par le dispositif peut être supérieure à cette tenue en tension Vmax.

Un mode de réalisation pallie tout ou partie des inconvénients des circuits et dispositifs connus de réinitialisation à la mise sous tension.

Un mode de réalisation prévoit un dispositif comprenant au moins un circuit, ledit au moins un circuit comprenant :
un premier noeud configuré pour recevoir un potentiel de référence ;
un deuxième noeud configuré pour recevoir une première tension continue, la première tension continue étant une tension d'alimentation ;
un troisième noeud configuré pour recevoir une deuxième tension continue ;
un premier transistor NMOS ayant sa grille connectée au deuxième noeud ;
un deuxième transistor NMOS ayant son drain connecté à la source du premier transistor et sa source connectée au deuxième noeud ;
un troisième transistor NMOS ayant sa grille connectée au deuxième noeud et sa source connectée au premier noeud ;
un quatrième transistor PMOS ayant son drain connecté au drain du troisième transistor et à la grille du deuxième transistor, et sa grille connectée à la source du premier transistor ;
un premier élément résistif connecté entre le drain du premier transistor et le troisième noeud ;
un deuxième élément résistif connecté entre la source du quatrième transistor et le troisième noeud ; et
un premier inverseur CMOS configuré pour être alimenté par la deuxième tension, une entrée du premier inverseur étant connectée au drain du troisième transistor et une sortie du premier inverseur étant configurée pour fournir un signal de réinitialisation.

Selon un mode de réalisation, chacun des premier et deuxième éléments résistifs est mis en œuvre par un transistor PMOS ayant sa grille connectée au premier noeud et sa source connectée au troisième noeud.

Selon un mode de réalisation, le circuit comprend en outre un élément capacitif connecté entre la grille et la source du premier transistor.

Selon un mode de réalisation, le circuit comprend en outre un deuxième inverseur CMOS configuré pour être alimenté par la deuxième tension, une entrée du deuxième inverseur étant connectée à la sortie du premier inverseur, et une sortie du deuxième inverseur étant configurée pour fournir un signal complémentaire du signal de réinitialisation.

Selon un mode de réalisation, les premier et deuxième éléments résistifs, et les premier et quatrième transistors sont dimensionnés de sorte que le quatrième transistor soit bloqué quand le premier transistor est passant.

Selon un mode de réalisation, la deuxième tension est aussi une tension d'alimentation.

Selon l'invention, le dispositif comprend:
au moins un circuit tel que défini ci-dessus, et
un circuit de génération de tension configuré pour fournir la deuxième tension continue à une valeur non nulle avant une mise sous tension et une montée en puissance de la première tension, la valeur non nulle étant adaptée à permettre une commutation à l'état passant du quatrième transistor dès la mise sous tension de la première tension.

Selon un mode de réalisation :
ledit au moins un circuit comprend au moins deux circuits tels que décrits ci-dessus ;
le dispositif comprend une porte logique CMOS configurée pour mettre en œuvre une fonction logique booléenne ET entre les signaux de réinitialisation fournis par lesdits au moins deux circuits,
dans lequel :
   les premiers noeuds desdits au moins deux circuits sont configurés pour recevoir le même potentiel de référence ;
   les troisièmes noeuds desdits au moins deux circuits sont configurés pour recevoir la deuxième tension fournie par le circuit de génération de tension, ladite deuxième tension étant une tension de référence ; et
   les deuxièmes noeuds desdits au moins deux circuits sont configurés chacun pour recevoir une première tension continue d'alimentation différente des premières tensions reçues par les deuxièmes noeuds des autres circuits.

Selon un mode de réalisation, la porte logique CMOS est configurée pour être alimentée par la deuxième tension fournie par le circuit de génération de tension.

Selon un mode de réalisation, le circuit de génération de tension est configuré pour fournir la deuxième tension continue de référence à sa valeur nominale avant la mise sous tension et la montée en puissance de chacune des premières tensions.

Selon un mode de réalisation, le circuit de génération de la deuxième tension de référence comprend :
un premier pont diviseur de tension connecté entre un premier noeud d'alimentation configuré pour recevoir l'une des premières tensions continues d'alimentation et un deuxième noeud d'alimentation configuré pour recevoir le potentiel de référence ;
un premier transistor MOS et un deuxième pont diviseur de tension résistif connectés en série entre les premier et deuxième noeuds d'alimentation, le premier transistor ayant sa grille connectée à un noeud intermédiaire du premier pont et sa source connectée au deuxième noeud d'alimentation ;
un premier circuit tampon configuré pour être alimenté par ladite première tension continue d'alimentation et comprenant une entrée connectée à un premier noeud intermédiaire du deuxième pont et une sortie configurée pour fournir la deuxième tension de référence ; et
un deuxième transistor MOS ayant son drain connecté à la sortie du premier circuit tampon et sa source connectée au premier noeud d'alimentation,
dans lequel le premier pont est configuré pour que le premier transistor soit bloqué lorsque ladite l'une des premières tensions continues d'alimentation est à une valeur inférieure à un premier seuil lui-même inférieur à une limite de tenue en tension des transistors, et
dans lequel le deuxième transistor est configuré pour être à l'état passant si le premier transistor est à l'état bloqué et inversement.

Selon un mode de réalisation, le circuit de génération de la deuxième tension de référence comprend :
un premier pont diviseur de tension connecté entre un premier noeud d'alimentation configuré pour recevoir l'une des premières tensions continues d'alimentation et un deuxième noeud d'alimentation configuré pour recevoir le potentiel de référence ;
un premier transistor MOS et un deuxième pont diviseur de tension résistif connectés en série entre les premier et deuxième noeuds d'alimentation, le premier transistor ayant sa grille connectée à un noeud intermédiaire du premier pont et sa source connectée au premier noeud d'alimentation ;
un deuxième transistor MOS et un troisième pont diviseur de tension résistif connectés en série entre les premier et deuxième noeuds d'alimentation, la source du deuxième transistor MOS étant connectée au deuxième noeud d'alimentation ;
un circuit tampon configuré pour être alimenté par ladite l'une des premières tensions continues d'alimentation et comprenant une entrée connectée à un premier noeud intermédiaire du troisième pont et une sortie configurée pour fournir la deuxième tension de référence ; et
un troisième transistor MOS ayant son drain connecté à la sortie du circuit tampon et sa source connectée au premier noeud d'alimentation ;
dans lequel le deuxième transistor est configuré pour être à l'état bloqué, respectivement passant, quand le premier transistor est à l'état bloqué, respectivement passant,
dans lequel le troisième transistor est configuré pour être à l'état passant si le deuxième transistor est à l'état bloqué et inversement, et
dans lequel le premier pont est configuré pour que le premier transistor soit bloqué lorsque ladite l'une des premières tensions continues d'alimentation est à une valeur inférieure à un premier seuil lui-même inférieur à une limite de tenue en tension des transistors.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple d'un circuit de réinitialisation à la mise sous tension ;
la figure 2 représente un mode de réalisation d'un circuit de réinitialisation à la mise sous tension ;
la figure 3 représente un mode de réalisation d'un dispositif de réinitialisation à la mise sous tension ;
la figure 4 représente, de manière schématique et sous la forme de blocs, un exemple d'un système électronique comprenant un circuit de génération de tension de référence selon un mode de réalisation ;
la figure 5 illustre, sous la forme d'un circuit, un mode de réalisation du circuit de génération de tension de référence de la figure 4 ;
la figure 6 illustre, sous la forme d'un circuit, un exemple de réalisation du circuit de génération de tension de référence de la figure 4 ;
la figure 7 représente, sous la forme d'un circuit, une variante de réalisation du circuit de la figure 5 ;
la figure 8 représente, sous la forme d'un circuit, une variante de réalisation du circuit de la figure 6 ;
la figure 9 représente, sous la forme d'un circuit, un exemple de mode de réalisation d'un circuit tampon analogique ; et
la figure 10 représente, sous la forme d'un circuit, un exemple d'un autre mode de réalisation d'un circuit tampon analogique

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

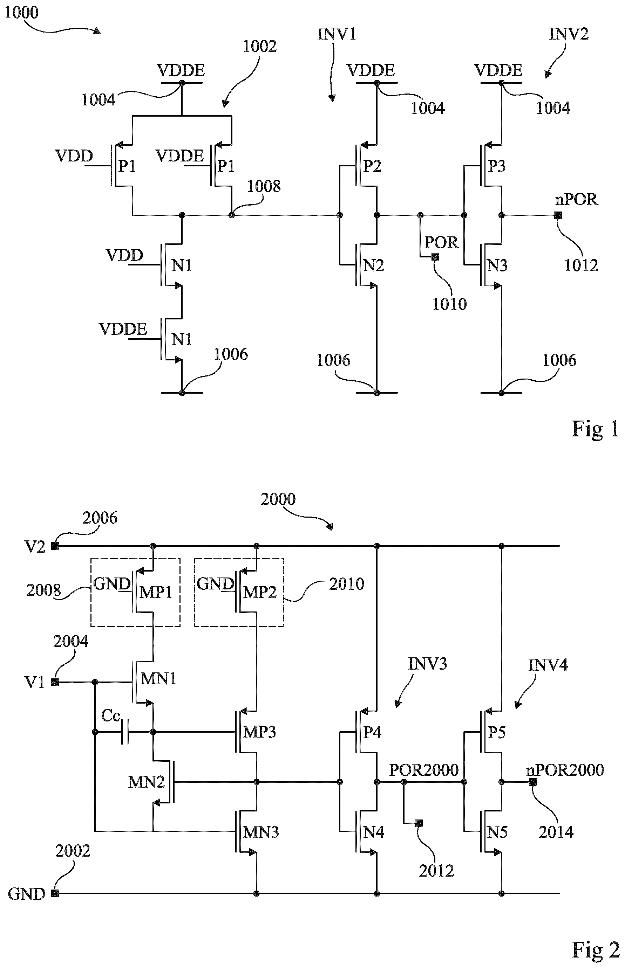

La figure 1 représente un exemple d'un circuit 1000 de réinitialisation à la mise sous tension.

Dans cet exemple, le circuit 1000 est configuré pour fournir un signal de réinitialisation POR à un état binaire bas correspondant, par exemple, à une tension nulle lorsqu'un circuit à alimenter avec deux tensions d'alimentation VDDE et VDD doit être réinitialisé, et à un état binaire haut correspondant, par exemple, à une tension de valeur égale à la valeur nominale de la tension VDEE lorsque la montée en puissance des deux tensions VDDE et VDD est terminée, c'est-à-dire lorsque ces deux tensions VDDE et VDD ont atteint leurs valeurs nominales respectives. Ainsi, l'état bas du signal POR provoque la réinitialisation du circuit à alimenter avec les tensions VDD et VDDE et cette phase de réinitialisation se termine lorsque toutes les tensions ont terminé leurs montées en puissance et que le signal POR commute à l'état haut.

Le circuit 1000 est alimenté par la tension VDDE ou VDD qui a la plus grande valeur nominale, à savoir VDDE dans cet exemple. Ainsi, le circuit 1000 comprend un noeud (ou rail) 1004 configuré pour recevoir la tension VDDE, et un noeud (ou rail) 1006 configuré pour recevoir un potentiel de référence GND, par exemple la masse.

Le circuit 1000 comprend une porte logique 1002 mise en œuvre en technologie CMOS (de l'anglais "Complementary MOS" - MOS complémentaire), c'est-à-dire une porte logique CMOS 1002. La porte 1002 est alimentée par la tension 1002.

La porte 1002 est configurée pour mettre en œuvre une fonction logique booléenne NON ET ("NAND" en anglais) entre les tensions VDDE et VDD, ces tensions VDDE et VDD étant fournies à des entrées respectives de la porte 1002. La porte logique 1002 fournit le résultat de cette opération logique booléenne sur un noeud 1008 de sortie de la porte 1002.

La porte 1002 comprend autant de transistors PMOS P1 qu'elle a d'entrées, c'est-à-dire deux transistors P1 dans cet exemple. Les transistors P1 sont connectés en parallèle entre les noeuds 1004 et 1008. Chaque transistor P1 a sa grille connectée à une entrée différente de la porte 1002. Par exemple, un premier transistor P1 a sa grille connectée à la tension VDD, ou, dit autrement, a sa grille configurée pour recevoir la tension VDD, et un deuxième transistor P1 a sa grille connectée à la tension VDDE ou, dit autrement, a sa grille configurée pour recevoir la tension VDDE.

En outre, la porte 1002 comprend autant de transistor NMOS N1 qu'elle a d'entrées, c'est-à-dire deux transistors N1 dans cet exemple. Les transistors N1 sont connectés en série entre les noeuds 1008 et 1006. Chaque transistor N1 a sa grille connectée à une entrée différente de la porte 1002. Par exemple, un premier transistor N1 a sa grille connectée à la tension VDD, et un deuxième transistor N1 a sa grille connectée à la tension VDDE.

Le circuit 1000 comprend en outre un inverseur INV1. L'inverseur INV1 est alimenté par la tension VDDE. L'inverseur a une entrée connectée au noeud 1008 de sortie de la porte 1002 et une sortie 1010 configuré pour fournir le signal POR.

L'inverseur INV1 est mis en œuvre en technologie CMOS. Plus particulièrement, l'inverseur INV1 comprend un transistor PMOS P2 connecté entre le noeud 1004 et la sortie 1010 et ayant sa grille connectée au noeud 1008, et un transistor NMOS N2 connectée entre la sortie 1010 et le noeud 1006 et ayant sa grille connectée au noeud 1008.

Dans cet exemple, le circuit 1000 comprend en outre un inverseur INV2. L'inverseur INV2 est alimenté par la tension VDDE. L'inverseur INV2 est mis en œuvre en technologie CMOS. L'inverseur INV2 a une entrée connectée à la sortie 1010 de l'inverseur INV1, et une sortie 1012 configurée pour fournir un signal nPOR complémentaire du signal POR. Plus particulièrement, l'inverseur INV2 comprend un transistor PMOS P3 connecté entre le noeud 1004 et la sortie 1012 et ayant sa grille connectée au noeud 1010, et un transistor NMOS N3 connectée entre la sortie 1012 et le noeud 1006 ayant sa grille connectée au noeud 1010.

Bien que l'on ait décrit ici un exemple de circuit 1000 surveillant la montée en puissance de deux tensions d'alimentation VDDE et VDD, la personne du métier est en mesure d'adapter cet exemple au cas où le circuit 1000 surveille la montée en puissance de plus de deux tensions d'alimentation, en augmentant le nombre d'entrées de la porte 1002.

Le circuit 1000 ne détecte que la montée en puissance de la tension d'alimentation VDDE ou VDD qu'il surveille qui se produit en dernier.

Si toutes les tensions d'alimentation surveillées par le circuit 1000 ont fini leurs montées en puissance, alors tous les transistors N1 sont passants, la sortie 1008 de la porte 1002 est tirée au potentiel GND, ou, dit autrement, une tension nulle est présente sur le noeud 1008, et le signal POR est à un état haut correspondant à la tension VDDE d'alimentation du circuit 1000.

Si toutes les tensions d'alimentation surveillées par le circuit 1000 ont finies leurs montées en puissance à l'exception d'au moins une des tensions d'alimentation surveillées qui est encore à une valeur nulle et qui n'est pas la tension d'alimentation du circuit 1000, alors la sortie 1008 est tirée à la tension d'alimentation VDDE, et le signal POR est à un état bas correspondant à une tension nulle.

En revanche, tant que la tension VDDE est absente, c'est à dire dans un état haute impédance, alors la sortie 1008 est dans un état haute impédance, tout comme le signal POR.

Avoir un signal POR dans un état indéfini alors que certaines alimentations surveillées par le circuit 100 ont déjà finies leurs montées en puissance n'est pas souhaitable. En effet, cela peut conduire à avoir des noeuds flottants dans le circuit à alimenter avec les tensions d'alimentation surveillées et recevant le signal POR. Or, lorsque le circuit à alimenter a des noeuds flottants et a déjà reçu des tensions d'alimentation ayant fini leurs montées en puissance, cela peut conduire à des disfonctionnements ou une destruction du circuit à alimenter.

Pour éviter que le signal POR soit dans un état indéfini alors qu'une des tensions surveillées par le circuit 1000 a fini sa montée en puissance, par exemple lorsque la tension VDD a atteint sa valeur nominale alors que la tension VDDE est absente, il a été proposé d'imposer une séquence d'allumage des tensions d'alimentation surveillées, par exemple d'imposer que la tension VDDE soit fournie avant la tension VDD. Cependant, imposer une séquence d'allumage des tensions d'alimentation n'est pas toujours possible et, plus généralement, il est souhaitable de ne pas imposer une telle séquence d'allumage.

Par ailleurs, lorsque la différence entre la valeur de la tension VDDE et la valeur d'au moins une autre des tensions surveillées peut prendre, lors de la mise sous tension et de la montée en puissance de ces deux tensions d'alimentation, des valeurs supérieures à la tenue en tension Vmax des transistors MOS dans une technologie donnée, alors le circuit 1000 ne peut pas être mis en œuvre dans cette technologie.

En outre, dans le circuit 1000, à la fin de la montée en puissance de toutes les tensions alimentations qu'il surveille, si l'une des tensions surveillées, par exemple la tension VDD, a une valeur nominale différente et plus faible que celle de la tension VDDE, alors le circuit consomme de l'énergie qui est proportionnelle à la différence entre ces valeurs nominales, ce qui n'est pas souhaitable.

A titre d'exemple, le circuit 1000 n'est donc pas adapté à une utilisation comme circuit de réinitialisation à la mise sous tension pour une mémoire de type RRAM (de l'anglais "Resistive Ramdom Acces Memory" - Mémoire résistive à accès aléatoire) alimentée par les tensions VDD et VDDE ayant par exemple des valeurs nominales respectivement sensiblement égales à 1,8 V et 3,3 V.

Bien que l'on ait décrit ici un exemple de stratégie de réinitialisation à l'allumage et un exemple de circuit 1000 mettant en œuvre cette stratégie, les autres stratégies connues de réinitialisation à l'allumage et les circuits connus les mettant en œuvre souffrent d'inconvénients similaires.

Par exemple, des stratégies connues de réinitialisation à l'allumage et des circuits connus les mettant en œuvre nécessitent une séquence imposée d'allumage des tensions d'alimentation qu'ils surveillent pour que le signal POR qu'ils fournissent à un circuit à alimenter avec ces tensions d'alimentation surveillées ne soit pas dans un état indéfini alors qu'au moins une des tensions surveillées a déjà finie sa montée en puissance.

Par exemple, des stratégies connues de réinitialisation à l'allumage et des circuits connus les mettant en œuvre ne peuvent pas être mis en œuvre dans des technologies données pour lesquelles la tenue en tension des transistors est inférieure à des valeurs prises par la différence entre deux des tensions surveillées lors de la mise sous tension et de la montée en puissance de ces dernières, par exemple les deux tensions VDD et VDDE dans le circuit 1000 précédemment décrits.

Par exemple, des circuits connus mettant en œuvre des stratégies connues de réinitialisation à l'allumage présentent une consommation statique non nulle et importante lorsque les tensions surveillées ont fini leurs montées en puissance et qu'au moins deux des tensions surveillées ont des valeurs nominales différentes.

Un autre exemple de circuit de réinitialisation à l'allumage (non illustré par une figure) est mis en œuvre à partir d'une porte NON ET à double alimentation. Dit autrement, cet autre circuit de réinitialisation comprend une porte NON ET similaire à la porte 1002 de la figure 1, à la différence que la source du transistor P1 recevant la tension VDDE sur sa grille est connecté à un noeud recevant la tension VDD, et non pas au noeud 1004 comme en figure 1. Cet autre circuit comprend, de préférence, l'inverseur INV1 connecté en sortie de la porte NON ET, et, de préférence, l'inverseur INV2 connecté en sortie de l'inverseur INV1.

Dans cet autre circuit non illustré, si la tension VDDE a fini sa montée en puissance alors que la tension VDD est nulle, la sortie de la porte NON ET est tirée à la tension VDDE par le transistor P1 commandé par la tension VDD, et, à l'inverse, si la tension VDD a fini sa montée en puissance alors que la tension VDDE est nulle, la sortie de la porte NON ET est tirée à la tension VDD par le transistor P1 commandé par la tension VDDE. Ainsi, le signal POR de sortie de l'inverseur INV1 est à l'état bas.

Toujours dans cet autre circuit non illustré, si la tension VDDE, respectivement VDD, est absente, ou, dit autrement, dans un état haute impédance, alors que la tension VDD, respectivement VDDE, a fini sa montée en puissance, alors la sortie de la porte NON ET à double alimentation est dans un état haute impédance, d'où il résulte, par exemple, que le signal POR de sortie de l'inverseur INV1 est également dans un état haute impédance.

Bien que cet autre circuit présente des avantages par rapport au circuit 1000, il est difficile d'adapter cet autre circuit de réinitialisation à l'allumage à des exemples où plus de deux tensions d'alimentation sont surveillées. En outre, cet autre circuit de réinitialisation à l'allumage présente au moins certains des inconvénients du circuit 1000, comme par exemple une consommation statique à la fin de la montée en puissance des tensions VDDE et VDD qui est proportionnelle à la différence entre ces deux tensions.

La figure 2 représente un mode de réalisation d'un circuit 2000 de réinitialisation à la mise sous tension.

Le circuit 2000 comprend un noeud 2002 configuré pour recevoir le potentiel de référence GND, un noeud 2004 configuré pour recevoir une première tension continue V1, la première tension continue étant une tension d'alimentation surveillées par le circuit 2000, et un noeud 2006 pour recevoir une autre tension continue V2.

Le circuit 2000 comprend un transistor NMOS MN1. Le transistor MN1 a sa grille connectée au noeud 2004. Le circuit 2000 comprend un transistor NMOS MN2. Le drain du transistor MN2 est connecté à la source du transistor MN1 et la source du transistor MN2 est connectée au noeud 2004. Le circuit 2000 comprend un transistor NMOS MN3. La grille du transistor MN3 est connectée au noeud 2004 et la source du transistors MN3 est connectée au noeud 2002. Le circuit 2000 comprend un transistor PMOS MP3. Le drain du transistor MP3 est connecté au drain du transistor MN3, le drain du transistor MN3 étant connectée à la grille du transistor MN2. La grille du transistor MP3 est connectée à la source du transistor MN1.

En outre, le circuit 2000 comprend un élément résistif 2008 connecté entre le drain du transistor MN1 et le noeud 2006. Par exemple, l'élément résistif 2008 a une borne connectée au drain du transistor MN1 et une borne connectée au noeud 2006. Le circuit 2000 comprend également un élément résistif 2010 connecté entre la source du transistor MP3 et le noeud 2006. Par exemple, l'élément résistif 2010 a une borne connectée à la source du transistor MP3 et une borne connectée au noeud 2006.

Le circuit 2000 comprend un inverseur INV3 mis en œuvre en technologie CMOS. L'inverseur INV3 est alimenté par la tension V2, et, plus généralement, le circuit 2000 est alimenté par la tension V2. Une entrée de l'inverseur INV3 est connectée au drain du transistor MP3, donc au drain du transistor MN3 et à la grille du transistor MN2. La sortie 2012 de l'inverseur INV3 est configurée pour fournir un signal POR2000 de réinitialisation à l'allumage.

A titre d'exemple, l'inverseur INV3 comprend un transistor PMOS P4 connecté entre le noeud 2006 et la sortie 2012 et ayant sa grille connectée aux drains des transistors MP3 et MN3, et un transistor NMOS N4 connectée entre la sortie 1012 et le noeud 2002 et ayant sa grille connectée aux drains des transistors MP3 et MN3.

Selon un mode de réalisation, le circuit 2000 comprend un élément capacitif Cc optionnel connecté entre la grille et la source du transistor MN1.

Selon un mode de réalisation, lorsque le circuit 2000 est configuré pour fournir, en plus du circuit POR2000 sur la sortie 2012 de l'inverseur INV3 qui est également une sortie du circuit 2000, un signal nPOR2000 complémentaire du signal POR2000, le circuit 2000 comprend un inverseur INV4 mis en œuvre en technologie CMOS. L'inverseur INV4 est alimenté par la tension V2. Une entrée de l'inverseur INV4 est connectée à la sortie 2012 de l'inverseur INV3, et une sortie 2014 de l'inverseur INV4 est configurée pour fournir le signal nPOR2000.

A titre d'exemple, l'inverseur INV4 comprend un transistor PMOS P5 connecté entre le noeud 2006 et la sortie 2014 et ayant sa grille à la sortie 2012, et un transistor NMOS N5 connecté entre la sortie 1014 et le noeud 2002 et ayant sa grille connectée à la sortie 2012.

Selon un mode de réalisation, chacun des éléments résistifs 2008 et 2010 est mis en œuvre par un transistor PMOS respectif ayant sa grille connectée au noeud 2002 de sorte à recevoir le potentiel GND et sa source connectée au noeud 2006. Par exemple, l'élément résistif 2008 est mis en œuvre par un transistor PMOS MP1 ayant sa grille commandée par le potentiel GND, sa source connectée au noeud 2006 et son drain connecté au drain du transistor MN1, et l'élément résistif 2010 est mis en œuvre par un transistor PMOS MP2 ayant sa grille commandée par le potentiel GND, sa source connectée au noeud 2006 et son drain connecté à la source du transistor MP3.

Un avantage de mettre en œuvre les éléments résistifs 2008 et 2010 avec les transistors PMOS MP1 et MP2 plutôt qu'avec des résistances est que, pour un encombrement similaire, les éléments résistifs auront des plus grandes valeurs de résistance, ce qui permet de réduire la consommation statique du circuit 2000 par rapport au cas où ces éléments résistifs auraient été mis en œuvre avec des résistances.

Toutefois, dans des variantes de réalisation, les éléments résistifs 2008 et 2010 sont mis en œuvre avec des résistances.

Pour illustrer le fonctionnement du circuit 2000, il est considéré, à titre d'exemple, le cas où l'allumage et la montée en puissance de la tension V1 sont postérieurs à la montée en puissance de la tension V2.

Cela est par exemple le cas lorsque les deux tensions sont des tensions continues d'alimentation, par exemple les tensions respectives VDD et VDDE, d'un circuit à alimenter dont l'initialisation est commandée par l'état bas du signal POR2000, et qu'une séquence d'allumage est imposée à ces tensions V1 et V2 pour que la tension V2 ait terminé sa montée en puissance avant l'allumage et la montée en puissance de la tension V1.

Cela peut également être le cas, par exemple, lorsque la tension V2 est une tension de référence VrefH fournie par un circuit de génération de tension de référence configuré pour que la tension VrefH soit stable et à sa valeur nominale avant et pendant l'allumage et la montée en puissance de la tension V1. Ce dernier cas se produit, par exemple, lorsque la tension V1 surveillée par le circuit 2000 est une tension d'alimentation d'un circuit à alimenter recevant un signal de réinitialisation à l'allumage déterminé par le signal POR2000 et que la tension V2 (ou VrefH) n'est pas une tension d'alimentation de ce circuit et ne dépend pas de la tension V1. Par exemple, la tension V2 (ou VrefH) peut alors être fournie par un circuit à saut de bande ("bandgap" en anglais) qui est par exemple alimenté par une tension d'alimentation qui n'est pas éteinte lorsque l'alimentation V1 est éteinte et/ou qui termine sa montée en puissance avant que la tension V1 ne soit allumée.

Ainsi, dès que la tension V1 est allumée et est alors à une valeur nulle, le transistor MN1 est à l'état bloqué, tout comme le transistor MN3. Par couplage capacitif entre la source et la grille du transistor MN1, soit via la capacité source-grille parasite du transistor MN1, soit via l'élément capacitif Cc, la grille du transistor MP3 reçoit une tension nulle ou presque, et le transistor MP3 commute donc à l'état passant. Il en résulte que l'inverseur INV3 reçoit sur son entrée une tension sensiblement égale à la tension V2 et que le signal POR2000 est alors à l'état bas correspondant à une tension nulle ou presque.

De manière avantageuse, dès l'allumage de la tension V1, le signal POR2000 se retrouve donc dans un état défini, à savoir l'état bas.

Par ailleurs, du fait que la tension sur le drain du transistor MP3 est égale à la tension V2 moins les chutes de tensions aux bornes de l'élément résistif 2010 et du transistor MP3, le transistor MN2 est passant et la grille du transistor MP3 reçoit la tension V1 nulle, ce qui permet de maintenir le transistor MP3 passant.

Ensuite, lors de la montée en puissance de la tension V1, tant que la tension V1 est trop faible pour commuter le transistor MN2 à l'état bloqué, la tension sur la grille du transistor MP3 suit l'augmentation de la tension V1. En même temps, dès que la tension V1 devient suffisante pour que le transistor MN1 commute à l'état passant et que le transistor MN3 commute à l'état passant, d'une part la tension sur la grille du transistor MP3 devient alors égale à la tension V2 moins les chutes de tension aux bornes de l'élément résistif 2008 et aux bornes du transistor MN1, et, d'autre part, la tension sur la grille du transistor MN2 est tirée vers le potentiel GND. Il en résulte d'une part que le transistor MP3 commute à l'état bloqué, et, d'autre part que le transistor MN2 commute à l'état bloqué. De plus, du fait que l'inverseur INV3 reçoit sur son entrée une tension nulle ou presque, le signal POR2000 est alors à son état haut correspondant à une tension sensiblement égale à la tension V2 à sa valeur nominale.

Selon un mode de réalisation correspondant au fonctionnement décrit ci-dessus, le transistor MP3 est configuré pour se bloquer quand le transistor MN1 devient passant, de sorte à réduire la consommation statique du circuit 2000. Les éléments résistifs 2008 et 2010, et les transistors MN1 et MP3 sont alors dimensionnés pour que le transistor MP3 se bloque quand le transistor MN1 devient passant. Par exemple, lorsque les éléments 2008 et 2010, par exemple les deux transistors MP1 et MP2, sont identiques, le transistor MP3 est dimensionné de sorte à avoir, en valeur absolue, une valeur de tension de seuil supérieure à celle du transistor MN1. Pour cela, il est par exemple prévu que le canal du transistor MP3 soit plus long que celui des transistors MN1, MN2 et MN3 lorsque les éléments résistifs MP1 et MP2 sont identiques.

Selon une variante de réalisation plus consommatrice d'énergie, pendant la montée en puissance de la tension V1, voire même à la fin de cette montée en puissance, le transistor MP3 peut rester passant alors que les transistors MN1 et MN3 sont passants. Toutefois, même si les deux transistors MN3 et MP3 sont passant simultanément, en raison de la chute de tension aux bornes de l'élément résistif 2010, l'entrée de l'inverseur INV3 recevra une tension plus proche d'une valeur nulle que de la valeur nominale de la tension V2, et le signal POR2000 sera alors à son état haut.

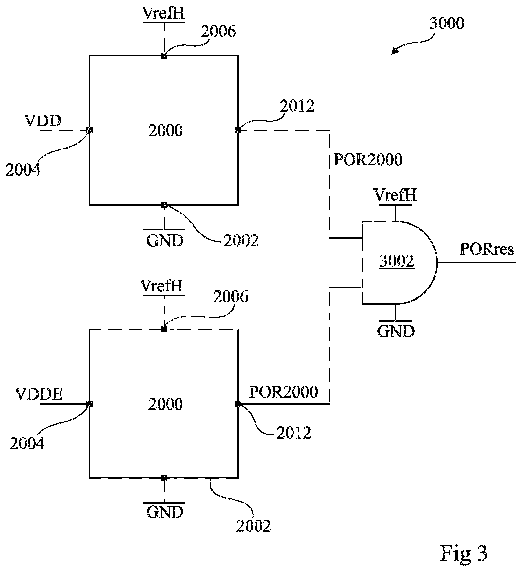

Il est considéré à titre d'exemple un cas où :
la tension V1 correspond à l'une des tensions d'alimentation d'un circuit à alimenter auquel doit être fourni un signal de réinitialisation dans un état défini dès que l'une de ses tensions d'alimentation est allumée, et
la tension V2 est une tension de référence VrefH ayant une valeur non nulle, de préférence sa valeur nominale, avant l'allumage et la montée en puissance de chacune des tensions d'alimentation du circuit à alimenter. Dans un tel cas, le circuit 2000 ne peut surveiller qu'une seule des tensions d'alimentation du circuit à alimenter. Pour surveiller toutes les tensions d'alimentation du circuit à alimenter, et lui fournir un signal de réinitialisation PORres à un état binaire, par exemple bas, défini dès que l'une de ces tensions d'alimentation est allumée, et à un autre état binaire, par exemple haut, dès que toutes ces tensions d'alimentation ont terminé leurs montées en puissance, il est proposé un dispositif de réinitialisation à l'allumage comprenant plusieurs circuits 2000, dont un exemple de mode de réalisation va être maintenant décrit en relation avec la figure 3.

La figure 3 représente un mode de réalisation d'un dispositif 3000 de réinitialisation à la mise sous tension.

Dans cet exemple, le dispositif 3000 est configuré pour surveiller les deux tensions d'alimentation VDD et VDDE d'un circuit à alimenter avec ces deux tensions d'alimentation, et pour fournir, à ce circuit à alimenter, un signal PORres d'initialisation à la mise sous tension qui :
soit à l'état bas dès que l'une quelconque des tensions surveillées VDDE et VDD est allumée et prend une valeur nulle, et
soit à l'état haut dès que toutes les tensions surveillées VDDE et VDD ont terminé leurs montées en puissance.

Le dispositif 3000 comprend autant de circuits 2000 qu'il surveille de tensions d'alimentation. Ainsi, dans cet exemple où le dispositif 3000 surveille les deux tensions VDD et VDDE, le circuit 3000 comprend deux circuits 2000. Toutefois, la personne du métier est en mesure d'adapter la description faite pour le cas où le dispositif 3000 surveille uniquement les deux tensions VDD et VDDE au cas où le dispositif 3000 surveille plus de trois tensions d'alimentation.

Les noeuds, ou entrées, 2006 des circuits 2000 reçoivent tous la même tension continue de référence VrefH.

Les noeuds 2002 des circuits 2000 reçoivent tous le même potentiel de référence GND.

En revanche, les noeuds, ou entrées, 2004 des circuits 2000 reçoivent chacun une tension d'alimentation à surveiller qui fait partie des tensions d'alimentation surveillées par le dispositif 3000 et qui est différente des tensions d'alimentation à surveiller reçues par les noeuds 2004 des autres circuits 2000. Ainsi, dans cet exemple où le dispositif 3000 surveille les deux tensions VDD et VDDE, un des deux circuits 2000 (en haut en figure 3) reçoit la tension VDD sur son noeud 2004, et l'autre des deux circuits 2000 (en bas en figure 3) reçoit la tension VDDE sur son noeud 2004.

En outre, le dispositif 3000 comprend une porte logique 3002 mise en œuvre en technologie CMOS et alimentée par la tension de référence VrefH. Plus particulièrement, la porte logique 3002 met en œuvre une fonction logique booléenne ET entre les signaux POR2000 fournis par les circuits 2000. Dans l'exemple de la figure 3, la porte 3002 comprend donc deux entrées recevant les signaux POR2000 des deux circuits 2000. La sortie de la porte 3002 fournit le signal PORres d'initialisation à la mise sous tension qui sera fourni au circuit à alimenter avec les tensions VDD et VDDE que surveille le dispositif 3000.

A titre d'exemple non illustré, la porte logique 3002 comprend, pour mettre en œuvre la fonction ET :
- des transistors PMOS assemblés en parallèle entre un noeud à la tension VrefH et un noeud intermédiaire de la porte 3002, et ayant chacun une grille connectée à une entrée correspondante de la porte ;
- des transistors NMOS assemblés en série entre le noeud intermédiaire et un noeud au potentiel GND, et ayant chacun une grille connectée à une entrée correspondante de la porte ; et
- un inverseur alimenté par la tension VrefH, ayant une entrée connectée au noeud intermédiaire et une sortie correspondant à la sortie de la porte.

Bien que cela ne soit pas représenté, selon un mode de réalisation, le dispositif 3000 comprend un circuit de génération de tension de référence configuré pour fournir la tension de référence VrefH.

Selon un mode de réalisation, le circuit de génération de tension de référence est configuré pour fournir la tension continue de référence VrefH à sa valeur nominale avant une mise sous tension et une montée en puissance de chacune des tensions VDD et VDDE surveillées par le dispositif 3000. Par exemple, le circuit de génération de la tension de référence est un circuit de type à saut de bande.

Ainsi, dès que l'une des tensions VDDE et VDD est mise sous tension (ou allumée), même si cette tension a une valeur nulle et que l'autre des tensions VDDE et VDD est dans un état haute impédance, du fait que la tension VrefH est fournie aux circuits 2000, le circuit 2000 recevant sur son noeud 2004 la tension qui vient d'être allumée va fournir un signal POR2000 à l'état bas. L'état bas d'au moins un signal POR2000 entraine que le signal PORres sera à l'état bas. Ensuite, tant que toutes les tensions VDDE et VDD n'ont pas fini leurs montées en puissance, le signal PORres reste à son état bas. Enfin, une fois que toutes les tensions surveillées VDD et VDDE ont fini leurs montées en puissance, les signaux POR2000 sont tous à leur état haut, d'où il résulte que le signal PORres est à l'état haut.

Le dispositif 3000 permet donc de surveiller les tensions VDDE et VDD et de fournir un signal PORres d'initialisation à la mise sous tension qui est dans un état bas défini dès que l'une des tensions VDDE et VDD est allumée, et qui ne commute ensuite à son état haut que lorsque que toutes les tensions surveillées VDD et VDDE ont fini leurs montées en puissance, ce qui n'était pas le cas du circuit 1000 de la figure 1. Le signal PORres est alors indépendant de la séquence suivant laquelle les tensions surveillées sont allumées et montent en puissance.

Dans un autre mode de réalisation, le circuit à alimenter avec les tensions VDDE et VDD comprend des structures cascodes étant alimentées chacune par la tension VDDE, et comprenant chacune un transistor ayant sa grille polarisée par la tension VrefH et un transistor ayant sa grille commandée par un signal binaire. Dans ce cas, le circuit de génération de la tension VrefH est configuré pour la tension VrefH permette une mise en œuvre des structures cascodes avec des transistors dont la tenue en tension Vmax est inférieure à des valeurs que peut prendre la différence entre les tensions VDDE et VDD alors que la séquence d'allumage des tension VDDE et VDD n'est pas imposée. Dans cet autre mode de réalisation, la tension VrefH de polarisation des structures cascodes peut avantageusement servir de tension VrefH pour les circuits 2000 précédemment décrits.

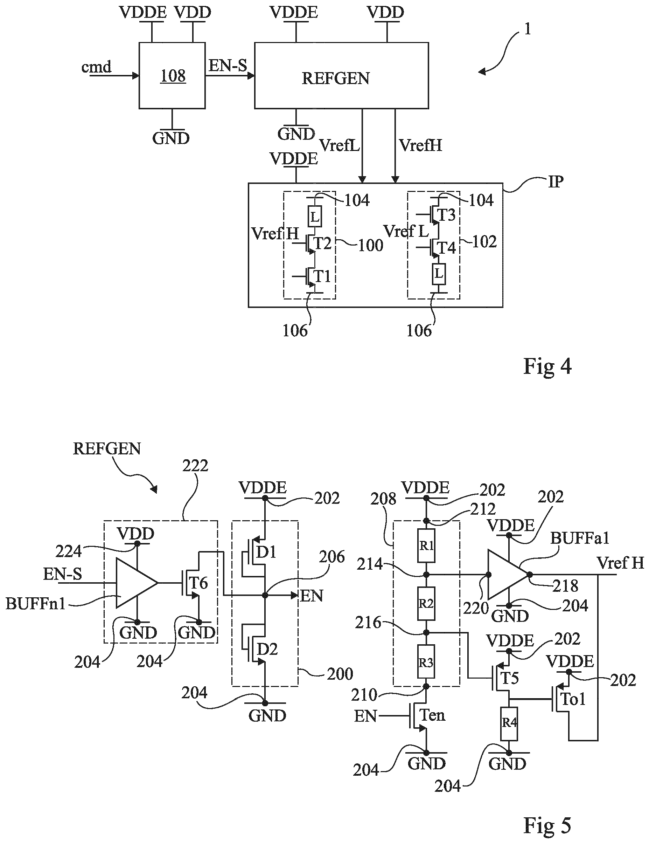

Des modes de réalisation et variantes de réalisation d'un tel circuit de génération d'une tension de référence ont été décrits dans la demande de brevet français FR2304777 déposée le 15 mai 2023, et vont être décrits ci-dessous en relation avec les figures 4 à 10 correspondant aux figures respectives 1 à 7 de la demande susmentionnée.

Il ressort des exemples ci-dessus que, de préférence, le dispositif comprend un circuit de génération de tension configuré pour fournir la tension V2, de sorte que la tension V2 soit non nulle avant une mise sous tension et une montée en puissance de la tension V1. Des premiers exemples ont été décrits dans lesquels, lorsque la tension V1 est mise sous tension et monte en puissance, la tension V2 est déjà à sa valeur nominale, c'est à dire, par exemple, que de la montée en puissance de la tension V2 est terminée. En outre, des deuxièmes exemples ont été décrits dans lesquels lorsque la tension V1 est mise sous tension et monte en puissance, la tension V2 est à une valeur non nulle, qui peut être différente de sa valeur nominale, par exemple, lorsque la tension V2 n'a pas fini sa montée en puissance quand débute celle de la tension V1. Dans ces deuxièmes exemples, la tension V2 peut dépendre d'une tension d'alimentation, par exemple VDDE, dont la montée en puissance n'est pas terminée lorsque la tension V1 débute sa montée en puissance. Ainsi, dans ces deuxièmes exemples, lorsque la tension V1 débute sa montée en puissance, la tension V2 peut avoir une valeur non nulle qui varie avec celle de la tension d'alimentation dont elle dépend, jusqu'à ce que la tension V2 atteigne sa valeur nominale. Dans ces deuxièmes exemples, la tension V2 est, par exemple, fournie par le circuit des figures 4 à 10 décrites ci-après.

De préférence, lorsque la tension V1 est mise sous tension et débute sa montée en puissance, la tension V2 a une valeur non nulle, nominale ou non, adaptée à permettre la commutation du transistor MP3 à l'état passant dès l'allumage de la tension V1 et le début de sa montée en puissance, de sorte que le signal sur le drain du transistor MP3 soit dans un état déterminé dès le début de cette montée en puissance de la tension V1. De préférence, lorsque la tension V1 est mise sous tension et débute sa montée en puissance, la valeur non nulle de la tension V2 est en outre adaptée à permettre le fonctionnement de l'inverseur INV3 de sorte que le signal POR2000 soit dans un état défini et non pas dans un état haute impédance, par exemple adaptée à permettre le fonctionnement des inverseurs INV3 et INV4 de sorte que les signaux POR2000 et nPOR200 soient dans des états définis et non pas dans des états hautes impédances.

La figure 4 représente, de manière schématique et sous la forme de blocs, un exemple d'un système électronique 1 comprenant un dispositif REFGEN de génération de tension de référence selon un mode de réalisation.

Plus particulièrement, le système 1, correspondant par exemple à une portion d'une puce de circuit intégré, comprend un dispositif IP, par exemple une mémoire résistive, et le dispositif REFGEN.

Le dispositif IP est alimenté par la tension d'alimentation VDDE, par exemple disponible sur un plot de connexion de la puce. A titre d'exemple, la tension VDDE a une valeur nominale sensiblement égale 3,3 V. Le dispositif IP comprend une borne configurée pour recevoir la tension VDDE, et une autre borne configurée pour recevoir le potentiel de référence GND, par exemple la masse, auquel est référencée la tension VDDE.

Le dispositif IP comprend des structures cascodes à transistors MOS. Par exemple, le dispositif IP comprend des structures cascodes 100 à transistors MOS à canal N et/ou des structures cascodes 102 à transistors MOS à canal P.

A titre d'exemple, chaque structure 100 comprend deux transistors MOS T1 et T2 à canal N connectés en série entre un noeud 104 recevant la tension VDDE et un noeud 106 recevant le potentiel GND. Le transistor T1 a sa source connectée au noeud 106 et son drain connecté à la source du transistor T2, la source du transistor T2 étant couplée au noeud 104 par une charge L. La grille du transistor T2 est configurée pour recevoir la tension de référence ou de polarisation VrefH. Le transistor T2 est, par exemple, appelé transistor cascode. La grille du transistor T1 est configurée pour recevoir une tension de commande comprise entre 0 V et la tension de polarisation VrefH.

De manière symétrique, à titre d'exemple, chaque structure 102 comprend deux transistors MOS T3 et T4 à canal P connectés en série entre les noeuds 104 et 106. Le transistor T2 a sa source connectée au noeud 104 et son drain connecté à la source du transistor T2, la source du transistor T2 étant couplée au noeud 106 par une charge L. La grille du transistor T4 est configurée pour recevoir une tension de référence VrefL. Le transistor T4 est, par exemple, appelé transistor cascode. La grille du transistor T3 est configurée pour recevoir une tension de commande comprise entre la tension de référence VrefL et la tension d'alimentation VDDE.

Dans la suite de la description, on appelle Vmax la tension maximale qui peut être appliquée entre la grille et la source ou entre la source et le drain de chacun des transistors du dispositif IP sans que cela n'endommage le transistor. Dit autrement, Vmax est la limite de tenue en tension des transistors MOS du dispositif IP.

De préférence, les tensions VrefL et VrefH ont des valeurs différentes. Par exemple, pour optimiser le fonctionnement des transistors à canal N et à canal P du dispositif IP, la tension VrefL est choisie égale à tension VDEE moins la tension VrefH. Toutefois, dans d'autres exemples, les tensions VrefL et VrefH ont la même valeur.

Les tensions VrefH et VrefL sont reçues par le dispositif IP.

Le dispositif REFGEN est configuré pour fournir les tensions VrefL et VrefH. Le dispositif REFGEN est alimenté par la tension VDDE. Le dispositif REFGEN a, par exemple, une borne recevant la tension VDDE, et une autre borne recevant le potentiel de référence GND.

Selon un mode de réalisation, le dispositif REFGEN est en outre configuré pour recevoir une tension d'alimentation VDD et un signal binaire EN-S.

La tension VDD a une valeur nominale plus faible que celle de la tension VDDE. En particulier, la tension VDD est inférieure à la limite de tenue en tension Vmax. Par exemple, le résultat de la soustraction de la valeur nominale de la tension VDD à celle de la tension VDDE est inférieure à la limite de tenue en tension des transistors T1, T2, T3 et T4 du dispositif IP. A titre d'exemple, la tension VDD est une tension générée par un circuit (non représenté) de la puce de circuit intégré comprenant le système 1.

Le signal EN-S est un signal binaire dont le niveau bas correspond à une tension nulle, et dont le niveau haut correspond à la tension VDD. Le signal EN-S est configuré pour être par défaut à son niveau bas. Le signal EN-S est en outre configuré pour être à son niveau bas lorsque la valeur courante de la tension VDDE est supérieure à la tension Vmax. Lorsque la valeur courante de la tension VDDE est inférieure à la tension Vmax, le niveau du signal EN-S est déterminé par un signal de commande cmd. Par exemple, la mise au niveau du signal EN-S avec le signal cmd lorsque la tension VDDE est inférieure à la tension Vmax correspond à un mode de fonctionnement basse consommation où la tension VDDE est à une valeur courante plus faible que sa valeur nominale, par exemple une valeur courante égale à la valeur nominale de la tension VDD.

A titre d'exemple, le système 1 comprend un circuit 108 configuré pour recevoir les tensions VDDE et VDD, le potentiel GND et le signal cmd, et pour fournir le signal EN-S. La mise en œuvre d'un tel circuit 108, et, plus généralement la génération du signal EN-S, sont à la portée de la personne de métier.

Dans une variante de réalisation, le circuit REFGEN ne reçoit pas le signal EN-S et la tension VDD.

Dans l'exemple de la figure 4, le dispositif IP comprend des structures 100 et 102, et le dispositif REFGEN fournit donc les deux tensions VrefH et VrefL. Dans d'autres exemples, le dispositif IP ne comprend pas de structure 100 et le dispositif REFGEN ne fournit alors que la tension VrefL, ou, à l'inverse, le dispositif IP ne comprend pas de structure 102 et le dispositif REFGEN ne fournit alors que la tension VrefH.

La figure 5 illustre, sous la forme d'un circuit, un mode de réalisation du circuit REFGEN de la figure 4. Dans ce mode de réalisation, le dispositif REFGEN est configuré pour ne fournir que la tension VrefH.

Selon un mode de réalisation, ce dispositif REFGEN fournit la tension VrefH à chaque circuit 2000 précédemment décrit et fait partie du dispositif 3000. En outre, le dispositif REFGEN peut être utilisé pour fournir la tension VrefH aux circuits 2000 décrits précédemment qu'il soit ou non utilisé pour fournir la tension VrefH au circuit IP.

Le dispositif REFGEN comprend un pont diviseur de tension 200. Le pont 200 est connecté entre un noeud 202 configuré pour recevoir la tension VDDE, et un noeud 204 configuré pour recevoir le potentiel GND. Par exemple, le pont 200 a une extrémité connectée au noeud 202 et une extrémité connectée au noeud 204.

Selon un mode de réalisation, le pont 200 comprend un ou plusieurs transistors MOS à canal P connectés en série entre le noeud 202 et un noeud 206 intermédiaire du pont 200. Chacun de ces transistors à canal P est monté en diode, ou, dit autrement, a son drain connecté à sa grille. Chacun de ces transistors à canal P a sa source du côté du noeud 202. En figure 5, ces transistors à canal P sont représentés sous la forme d'un seul transistor MOS à canal P, D1. De manière symétrique, le pont 200 comprend un ou plusieurs transistors MOS à canal N connectés en série entre le noeud 206 et le noeud 204. Chacun de ces transistors à canal N est monté en diode, ou, dit autrement, a son drain connecté à sa grille. Chacun de ces transistors à canal N a sa source du côté du noeud 204. En figure 5, ces transistors à canal N sont représentés sous la forme d'un seul transistor MOS à canal N, D2.

Selon une variante de réalisation, les transistors MOS à canal P du pont 200 sont remplacés par des diodes, par exemple des diodes ayant leurs anodes du côté du noeud 202, et les transistors MOS à canal N du pont 200 sont aussi remplacés par des diodes, par exemple des diodes ayant leurs anodes du côté du noeud 206.

Selon une autre variante de réalisation, les transistors à canal P du pont 200 sont remplacés par un élément résistif comprenant une ou plusieurs résistances en série entre les noeuds 202 et 206, et les transistors à canal N du pont 200 sont remplacés par un autre élément résistif comprenant une ou plusieurs résistances en série entre les noeud 206 et 204.

Le dispositif REFGEN comprend un transistor MOS Ten et un pont diviseur de tension résistif 208, le transistor Ten et le pont 208 étant connectés en série entre les noeuds 202 et 204.

Le transistor Ten a sa grille connectée au noeud 206 sur lequel est disponible une tension EN. La source du transistor Ten est connectée au noeud 204 dans le mode de réalisation de la figure 5. Dans le mode de réalisation de la figure 5, le transistor Ten est à canal N.

Le pont diviseur 208 a une extrémité 210 connectée au drain du transistor Ten. Le pont diviseur 208 a une autre extrémité 212 connectée au noeud 202 dans le mode de réalisation de la figure 5.

Le pont 208 comprend, par exemple, au moins trois éléments résistifs R1, R2 et R3. Chaque élément résistif R1, R2, R3 du pont 208 peut correspondre à une unique résistance ou à une association en série et/ou parallèle de plusieurs résistances. A titre d'exemple, l'élément R1 est connecté entre l'extrémité 212 et un noeud intermédiaire 214 du pont 208, l'élément R2 est connecté entre le noeud 214 et un autre noeud intermédiaire 216 du pont 208, et l'élément R3 est connecté entre le noeud 216 et l'extrémité 210 du pont.

Le dispositif REFGEN comprend un circuit tampon BUFFa1. Le circuit BUFFa1 est alimenté par la tension VDDE. Par exemple, le circuit BUFFa1 a une borne connectée au noeud 202 et une borne connectée au noeud 204.

Le circuit BUFFa1 est un circuit tampon analogique. Dit autrement, le circuit BUFFa1 est configuré pour fournir sur sa sortie 218 une tension ayant une valeur identique à celle d'une tension qu'il reçoit sur son entrée 220, tout en assurant une isolation entre son entrée et sa sortie. Dit encore autrement, le circuit BUFFa1 est un circuit suiveur à gain unitaire.

L'entrée 218 du circuit BUFFa1 est connectée à un noeud intermédiaire du pont 208, par exemple au noeud 214. La sortie 220 du circuit BUFFa1 fournit la tension VrefH.

Le dispositif REFGEN comprend en outre un transistor MOS To1. Le drain du transistor To1 est connecté à la sortie du circuit BUFFa1. La source du transistor To1 est connectée au noeud 202 dans le mode de réalisation de la figure 5 où le dispositif REFGEN est configuré pour fournir la tension VrefH. Dans le mode de réalisation de la figure 5, le transistor To1 est à canal P.

Le transistor To1 est configuré pour être à l'état passant lorsque le transistor Ten est à l'état bloqué, et pour être à l'état bloqué lorsque le transistor Ten est à l'état passant. Plus particulièrement, le transistor To1 est configuré pour que son état passant ou bloqué soit déterminé par une valeur de tension sur un noeud intermédiaire du pont diviseur 208, par exemple sur le noeud 216 du pont 208.

Dans l'exemple de la figure 5, le dispositif REFGEN comprend un transistor MOS à canal P T5 et un élément résistif R4 en série entre les noeuds 202 et 204. Le transistor T5 a sa grille connectée au noeud 216 du pont 208, sa source connectée au même noeud 202 que la source du transistor To1, et son drain couplé au noeud 204 par l'élément R4. La grille du transistor To1 est connectée au drain du transistor T5.

Dans le circuit REFGEN, le pont diviseur 200 est configuré pour que le transistor Ten soit à l'état bloqué si la tension VDDE est inférieure à un seuil VT1, par exemple sensiblement égal à 0,9 V. De préférence, le seuil VT1 est inférieur la tension Vmax. A l'inverse, le pont diviseur 200 est configuré pour que le transistor Ten soit passant si la tension VDDE est supérieure au seuil VT1. Plus particulièrement, le pont diviseur 200 est configuré pour avoir le fonctionnement ci-dessus lorsqu'il est pris seul, c'est-à-dire lorsqu'aucun circuit ne vient modifier directement le potentiel du noeud 206, par exemple en tirant ce noeud 206 à GND ou VDDE.

Ainsi, lorsque le pont 200 est pris seul et que la tension VDDE est inférieure au seuil VT1, la tension EN est inférieure au seuil du transistor Ten qui est alors à l'état bloqué. Il en résulte que le noeud 216 est à la tension VDDE, et donc que le transistor T5 est à l'état bloqué. L'état bloqué du transistor T5 entraîne que la grille du transistor To1 reçoit le potentiel GND et donc que le transistor To1 est à l'état passant. La sortie 218, donc la tension VrefH, est alors tirée à la tension VDDE. Dit autrement, tant que la tension VDDE est inférieure au seuil VT1, la tension VrefH suit la tension VDDE. A l'inverse, lorsque le pont 200 est pris seul et que la tension VDDE est supérieure ou égale au seuil VT1, la tension EN est suffisante pour que le transistor Ten soit passant, d'où il résulte que le transistor T5 devient passant, cet état passant du transistor T5 forçant le transistor To1 à l'état bloqué. La tension VrefH est alors égale à la tension sur l'entrée 220 du circuit BUFFa1. A titre d'exemple, le pont diviseur 208 est configurée pour que, lorsque le transistor Ten est passant, la tension sur l'entrée 220 du circuit BUFFa1 soit égale à 0,55 fois la tension VDDE lorsque la sortie 218 du circuit BUFFa1 fournit la tension VrefH.

Dans un mode de réalisation (non illustré), le circuit REFGEN ne reçoit pas le signal EN-S et la tension VDD.

Dans un autre mode de réalisation, comme cela est illustré par la figure 5, le dispositif REFGEN reçoit le signal EN-S et la tension VDD. Le dispositif REFGEN comprend alors un circuit 222 configuré pour recevoir le signal EN-S et pour tirer, uniquement lorsque le signal EN-S est à son niveau haut, le noeud 206 à celui du potentiel GND et de la tension VDDE qui met le transistor Ten à l'état bloqué lorsqu'il est appliqué sur la grille du transistor. Dans le mode de réalisation de la figure 5 où le transistor Ten est à canal N et a sa source connectée au noeud 204, le circuit 222 est configuré pour tirer le noeud 206 au noeud 204 lorsque le signal EN-S est à son niveau haut.

Lorsque la tension VDDE est inférieure à Vmax et que le signal cmd commande le niveau haut du signal EN-S, la prévision du circuit 222 permet que la tension VrefH soit égale à la tension du noeud 202 auquel est connectée la source du transistor To1. A titre d'exemple, un tel fonctionnement permet que, dans un mode basse alimentation où la tension VDDE est à une valeur faible par rapport à sa valeur nominale et inférieure à la tension Vmax, par exemple une valeur faible égale à la valeur nominale de la tension VDD, la tension VrefH soit à une valeur permettant le fonctionnement des structures cascodes 100 du dispositif IP (figure 4).

Dans le mode de réalisation de la figure 5, le circuit 222 comprend un circuit tampon BUFFn1 et un transistor MOS à canal N T6. Le circuit BUFFn1 est alimentée par la tension VDD. Par exemple, le circuit BUFFn1 a une borne connectée au noeud 204 et une borne connectée à un noeud 224 configuré pour recevoir la tension VDD.

Le circuit BUFFn1 est un circuit tampon numérique. Le circuit BUFFn1 est donc configuré pour fournir sur sa sortie 226 un signal numérique au niveau haut (VDD) lorsque son entrée 228 reçoit le niveau haut du signal EN-S, et au niveau bas (GND) lorsque son entrée reçoit le niveau bas (GND) du signal EN-S, tout en assurant une isolation entre son entrée et sa sortie. A titre d'exemple, le circuit BUFFn1 comprend deux inverseurs en série entre son entrée 228 et sa sortie 226.

Le transistor T6 a sa source connectée au noeud 204, sa grille connectée à la sortie 226 du circuit BUFFn1 et son drain connecté au noeud 206 du pont 200.

On a décrit ci-dessus en relation avec la figure 5, un mode de réalisation où le dispositif REFGEN est configuré pour fournir la tension VrefH, ce qui implique que le transistor To1 a sa source connectée au noeud 202.

Dans une variante de réalisation (non illustrée) de mise en œuvre du dispositif REFGEN, le dispositif décrit en relation avec la figure 5 est configuré pour générer la tension VrefL et n'est alors pas utilisé pour fournir la tension VrefH aux circuits 2000. Dans cette variante, le transistor To1 est à canal N, et a sa source connectée au noeud 204. Dans une telle variante, le transistor To1 reste commandé à partir d'une tension sur un noeud intermédiaire du pont 208, par exemple sur le noeud 216, de sorte à être passant lorsque le transistor Ten est bloqué, et à être bloqué lorsque le transistor Ten est passant. Dans une telle variante, la grille du transistor To1 est, par exemple, connectée au noeud 216, le transistor T5 et l'élément résistif R4 pouvant être omis. Dans une telle variante, la tension VrefL est alors fournie sur la sortie du circuit BUFFa1 à la place de la tension VrefH, la tension VrefL étant nulle tant que le transistor Ten est bloqué et égale à la tension sur le noeud 214 lorsque le transistor Ten est passant. A titre d'exemple, quand la sortie 218 du circuit BUFFa1 fournit la tension VrefL, le pont 208 est configuré pour que la tension sur le noeud 214 soit égale à 0,45 fois la tension VDDE lorsque le transistor Ten est passant.

Le dispositif REFGEN décrit en relation avec la figure 5 présente l'avantage de pouvoir être mis en œuvre avec des transistors MOS similaires à ceux du dispositif IP, c'est-à-dire des transistors MOS ayant une tenue en tension Vmax. En outre, en utilisant la tension VrefH comme tension appliquée au noeud 2006 des circuits 2000, ces derniers pourront eux aussi être mis en œuvre avec des transistors MOS ayant une tenue en tension Vmax.

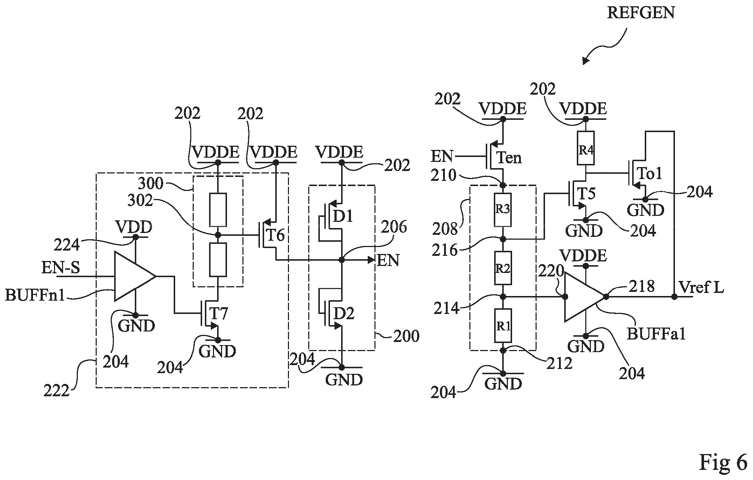

La figure 6 illustre, sous la forme d'un circuit, un autre exemple de réalisation du circuit REFGEN de la figure 4. Dans cet exemple de réalisation, le dispositif REFGEN est configuré pour ne fournir que la tension VrefL, et n'est donc pas utilisé pour fournir la tension VrefH aux circuits 2000.

Le dispositif REFGEN de la figure 6 comprend de nombreux éléments en commun avec celui de la figure 5, et seules les différences entre ces deux dispositifs sont ici mises en exergue. En particulier, sauf indication contraire, tous ce qui a été indiqué pour le dispositif REFGEN décrit en relation avec la figure 5 s'applique au dispositif REFGEN de la figure 6.

Le dispositif REFGEN comprend le pont diviseur de tension 200, le pont diviseur de tension résistif 208, le circuit tampon BUFFa1, le transistor Ten et le transistor To1.

Le transistor Ten et le pont 208 sont connectés en série entre les noeuds 202 et 204. Toutefois, à la différence de ce qui a été décrit en relation avec la figure 5, en figure 6, le transistor Ten est à canal P et a sa source connectée au noeud 202, l'extrémité 212 du pont diviseur 208 étant donc connectée au noeud 204.

En outre, dans le mode de réalisation de la figure 6, la sortie 218 du circuit tampon BUFFa1 fournit la tension VrefL et non pas la tension VrefH comme en figure 5. L'entrée 218 du circuit BUFFa1 est connectée à un noeud intermédiaire du pont 208, par exemple au noeud 214.

Dans le mode de réalisation de la figure 6 où le dispositif REFGEN est configuré pour fournir la tension VrefL, la source du transistor To1 est connectée au noeud 204 et le transistor To1 est à canal N. Comme en figure 5, dans le dispositif REFGEN de la figure 6, le transistor To1 est configuré pour être à l'état passant lorsque le transistor Ten est à l'état bloqué, et pour être à l'état bloqué lorsque le transistor Ten est à l'état passant. Plus particulièrement, le transistor To1 est configuré pour que son état passant ou bloqué soit déterminé par une valeur de tension sur un noeud intermédiaire du pont diviseur 208, par exemple sur le noeud 216 du pont 208.

Dans l'exemple de la figure 6, le dispositif REFGEN comprend le transistor MOS T5 et l'élément résistif R4 en série entre les noeud 202 et 204. Toutefois, par rapport à ce qui a été décrit en relation avec la figure 5, en figure 6 le transistor T5 est à canal N et a sa source connectée au noeud 204.

Comme en figure 5, en figure 6 le pont diviseur 200 est configuré pour que le transistor Ten soit à l'état bloqué si la tension VDDE est inférieure à un seuil VT1, par exemple sensiblement égal à 0,9 V, et pour que le transistor Ten soit passant si la tension VDDE est supérieure au seuil VT1. Plus particulièrement, le pont diviseur 200 est configuré pour avoir le fonctionnement ci-dessus lorsqu'il est pris seul.

Ainsi, lorsque le pont 200 est pris seul et que la tension VDDE est inférieure au seuil VT1, l'écart entre les tensions EN et VDDE n'est pas suffisant pour que le transistor Ten soit passant. L'état bloqué du transistor Ten implique que le noeud 216 est au potentiel GND d'où il résulte que le transistor T5 est à l'état bloqué et que la grille du transistor To1 reçoit la tension VDDE. Le transistor To1 est alors à l'état passant et la tension VrefL est nulle. A l'inverse, lorsque le pont 200 est pris seul et que la tension VDDE est supérieure ou égale au seuil VT1, l'écart entre les tensions EN et VDDE est suffisant pour que le transistor Ten soit passant, d'où il résulte que le transistor T5 devient passant ce qui met le transistor To1 à l'état bloqué. La tension VrefL est alors égale à la tension sur l'entrée 220 du circuit BUFFa1. A titre d'exemple, quand la sortie 218 du circuit BUFFa1 fournit la tension VrefL, le pont 208 est configuré pour que la tension sur le noeud 214 soit égale à 0,45 fois la tension VDDE lorsque le transistor Ten est passant.

Dans un mode de réalisation (non illustré), le circuit REFGEN ne reçoit pas le signal EN-S et la tension VDD.

Dans un autre mode de réalisation, comme cela est illustré par la figure 6, le dispositif REFGEN reçoit le signal EN-S et la tension VDD. Le dispositif REFGEN comprend alors le circuit 222 configuré pour recevoir le signal EN-S et pour tirer, lorsque le signal EN-S est à son niveau haut, le noeud 206 à celui du potentiel GND et de la tension VDDE qui commande l'état bloqué du transistor Ten. Ainsi, dans le mode de réalisation de la figure 6 où le transistor Ten est à canal P et a sa source connectée au noeud 202, le circuit 222 est configuré pour tirer le noeud 206 au noeud 202 lorsque le signal EN-S est à son niveau haut.

Lorsque la valeur courante de la tension VDDE est inférieure à Vmax et que le signal cmd commande le niveau haut du signal EN-S, la prévision du circuit 222 permet que la tension VrefL soit égale à la tension du noeud 204 auquel est connectée la source du transistor To1. A titre d'exemple, un tel fonctionnement permet que, dans un mode basse alimentation où la tension VDDE est à une valeur faible par rapport à sa valeur nominale et inférieure à la tension Vmax, la tension VrefL soit à une valeur permettant le fonctionnement des structures cascodes 102 du dispositif IP (figure 4).

Dans le mode de réalisation de la figure 6, le circuit 222 comprend le circuit tampon BUFFn1 et le transistor MOS T6. Toutefois, dans cet exemple, le transistor T6 est à canal P et a sa source connectée au noeud 202, et sa grille n'est pas connectée à la sortie du circuit BUFFn1. Le circuit 222 comprend alors en outre un transistor MOS à canal N T7 et un pont diviseur de tension 300 connecté en série entre les noeuds 202 et 204. Le pont 300, de préférence un pont diviseur résistif, est connecté entre le noeud 202 et le transistor T7. Le transistor T7 a sa source connectée au noeud 204, sa grille connectée à la sortie du circuit BUFFn1 et son drain connecté au pont 300. La grille du transistor T6 est connectée à un noeud intermédiaire 302 du pont 300.

Dans la mise en œuvre décrite ici du circuit 222, lorsque la tension VDDE est supérieure à la tension Vmax et que le signal EN-S est donc à son niveau bas, le transistor T7 a alors une tension grille-source nulle mais une tension drain-source égale à la VDDE et donc supérieure à la tenue en tension Vmax des transistors du dispositif IP. Ainsi, le transistor T7 est choisi pour pouvoir tenir la tension VDDE sur son drain. Par exemple, le transistor T7 est un transistor à drain étendu.

Le dispositif REFGEN décrit en relation avec la figure 6 présente l'avantage de pouvoir être mis en œuvre avec des transistors MOS similaires à ceux du dispositif IP, c'est-à-dire des transistors MOS ayant une tenue en tension Vmax, sauf en ce qui concerne le transistor T7 qui est dimensionné pour pouvoir tenir la tension VDDE sur son drain.

On a décrit ci-dessus en relation avec la figure 6, un mode de réalisation où le dispositif REFGEN est configuré pour fournir la tension VrefL, ce qui implique que le transistor To1 a sa source connectée au noeud 204.

Dans une variante de réalisation, le dispositif décrit en relation avec la figure 6 est configuré pour générer la tension VrefH et peut être utilisé pour fournir la tension VrefH aux circuits 2000. Dans ce cas, le transistor To1 est à canal P, et a sa source connectée au noeud 202. Dans une telle variante, le transistor To1 reste commandé à partir d'une tension sur un noeud intermédiaire du pont 208, par exemple le noeud 216, de sorte à être passant lorsque le transistor Ten est bloqué, et à être bloqué lorsque le transistor Ten est passant. Dans une telle variante, la grille du transistor To1 est, par exemple, connectée au noeud 216, le transistor T5 et l'élément résistif R4 pouvant être omis. Dans une telle variante, la tension VrefH est alors fournie sur la sortie du circuit BUFFa1 à la place de la tension VrefL, la tension VrefH suivant la tension VDDE tant que le transistor Ten est bloqué et étant égale à la tension sur le noeud 214 lorsque le transistor Ten est passant. A titre d'exemple, quand la sortie 218 du circuit BUFFa1 fournit la tension VrefH, le pont 208 est configuré pour que la tension sur le noeud 214 soit égale à 0,55 fois la tension VDDE lorsque le transistor Ten est passant.

Selon un mode de réalisation, ce dispositif REFGEN selon la variante décrite ci-dessus en relation avec la figure 6 fournit la tension VrefH à chaque circuit 2000 précédemment décrit et fait partie du dispositif 3000. En outre, le dispositif REFGEN peut être utilisé pour fournir la tension VrefH aux circuits 2000 décrits précédemment qu'il soit ou non utilisé pour fournir la tension VrefH au circuit IP.

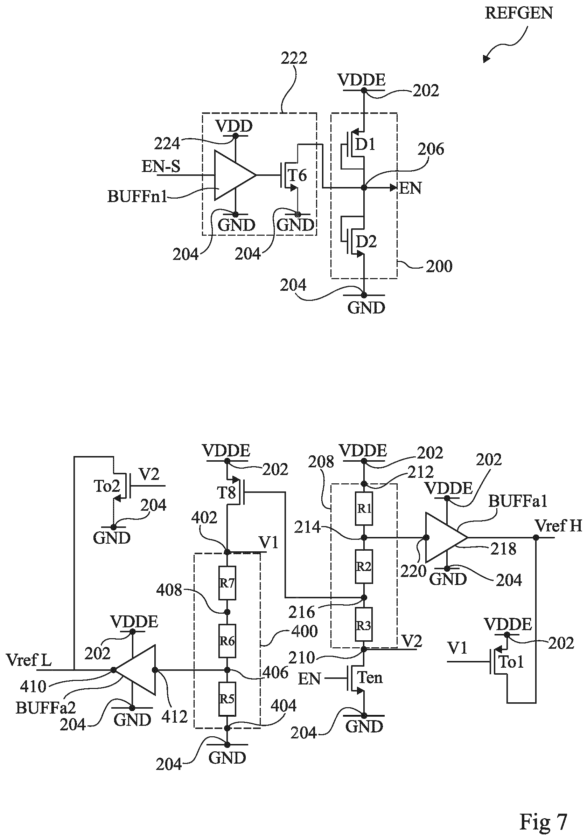

La figure 7 représente, sous la forme d'un circuit, une variante de réalisation du circuit REFGEN de la figure 5. Par rapport au circuit REFGEN de la figure 5 qui est configuré pour fournir la tension VrefH, le circuit REFGEN de la figure 7 est configuré pour générer la tension VrefH et la tension VrefL.

Selon un mode de réalisation, ce dispositif REFGEN fournit la tension VrefH à chaque circuit 2000 précédemment décrit et fait partie du dispositif 3000. En outre, le dispositif REFGEN peut être utilisé pour fournir la tension VrefH aux circuits 2000 décrits précédemment qu'il soit ou non utilisé pour fournir la tension VrefH au circuit IP.

Le dispositif REFGEN de la figure 7 comprend de nombreux éléments en commun avec celui de la figure 5, et seules les différences entre ces deux dispositifs sont ici mises en exergue. En particulier, sauf indication contraire, tous ce qui a été indiqué pour le dispositif REFGEN décrit en relation avec la figure 5 s'applique au dispositif REFGEN de la figure 7.

Par rapport au dispositif REFGEN de la figure 5, le dispositif REFGEN de la figure 7 comprend en outre un pont diviseur de tension résistif 400 et un transistor MOS T8 en série entre les noeuds 202 et 204.

La source du transistor T8 est connectée à celui des noeuds 202 et 204 auquel n'est pas connectée la source du transistor Ten, c'est-à-dire au noeud 202 dans le mode de réalisation de la figure 7. Dans le mode de réalisation de la figure 7, le transistor T8 est à canal P.

Le transistor T8 est configuré pour être passant, respectivement bloqué, lorsque le transistor Ten est passant, respectivement bloqué. Dans le mode de réalisation de la figure 7, Le transistor T8 a sa grille connectée à un noeud intermédiaire du pont 208, par exemple au noeud 216.

Le pont diviseur 400 a une extrémité 402 connectée au drain du transistor T8. Le pont diviseur 400 a une autre extrémité 404 connectée au noeud 204 dans le mode de réalisation de la figure 7.

Le pont 400 comprend, par exemple, au moins trois éléments résistifs R5, R6 et R7. Chaque élément résistif R5, R6, R7 du pont 400 peut correspondre à une unique résistance ou à une association en série et/ou parallèle de plusieurs résistances. A titre d'exemple, l'élément R5 est connecté entre l'extrémité 404 et un noeud intermédiaire 406 du pont 400, l'élément R6 est connecté entre le noeud 406 et un autre noeud intermédiaire 408 du pont 400, et l'élément R7 est connecté entre le noeud 408 et l'extrémité 402 du pont 400.

Par rapport au dispositif REFGEN de la figure 5, le dispositif REFGEN de la figure 7 comprend un circuit tampon BUFFa2. Le circuit BUFFa2 est alimenté par la tension VDDE. Par exemple, le circuit BUFFa2 a une borne connectée au noeud 202 et une borne connectée au noeud 204.

Le circuit BUFFa2 est un circuit tampon analogique. Dit autrement, le circuit BUFFa2 est configuré pour fournir sur sa sortie 410 une tension ayant une valeur identique à celle d'une tension qu'il reçoit sur son entrée 412, tout en assurant une isolation entre son entrée et sa sortie. Dit encore autrement, le circuit BUFFa2 est un circuit suiveur à gain unitaire.

L'entrée 412 du circuit BUFFa2 est connectée à un noeud intermédiaire du pont 400, par exemple au noeud 406. Dans le mode de réalisation de la figure 7, la sortie 410 du circuit BUFFa2 fournit la tension VrefL.

Le dispositif REFGEN comprend en outre un transistor MOS To2. Le drain du transistor To2 est connecté à la sortie du circuit BUFFa2. La source du transistor To2 est connectée au noeud 204 dans le mode de réalisation de la figure 7 où le circuit BUFFa2 est configuré pour fournir la tension VrefL. Dit autrement, la source du transistor To2 et la source du transistor To1 sont connectées à des noeuds respectifs différents parmi les noeuds 202 et 204. Dans le mode de réalisation de la figure 7, le transistor To2 est à canal N.

Le transistor To2 est configuré pour être à l'état passant lorsque le transistor T8 est à l'état bloqué, et pour être à l'état bloqué lorsque le transistor T8 est à l'état passant.

Plus particulièrement, dans le mode de réalisation de la figure 7, le transistor To2 est configuré pour que son état passant ou bloqué soit déterminé par une valeur de tension V2 sur un noeud du pont diviseur 208, par exemple sur le noeud 210 du pont diviseur 300, et le transistor To1 est configuré pour que son état passant ou bloqué soit par une valeur de tension V1 sur un noeud du pont diviseur 400, par exemple sur le noeud 402 du pont 400. Le transistor To1 a sa grille couplée, de préférence connectée, au noeud 402, le transistor To2 ayant sa grille couplée, de préférence connectée, au noeud 210.

Dans une variante de réalisation (non illustrée) le dispositif REFGEN comprend un transistor MOS et un élément résistif en série entre les noeuds 202 et 204, identiques au transistor T5 et à l'élément R4 de la figure 5, et connectés entre eux, au pont 208 et au transistor To1 de la même façon que le transistor T5 et l'élément R4 en figure 5. Le transistor To1 n'est alors pas commandé par la tension V1 du pont 400. Par rapport au mode de réalisation illustré en figure 7, cette variante est plus encombrante.

Dans une autre variante de réalisation, pouvant être combinée avec la variante de réalisation ci-dessus, le dispositif REFGEN comprend un transistor MOS et un élément résistif en série entre les noeuds 202 et 204, identiques au transistor T5 et à l'élément R4 de la figure 6, et connectés entre eux, au pont 208 et au transistor To1 de la même façon que le transistor T5 et l'élément R4 en figure 6. Le transistor To2 n'est alors pas commandé par la tension V2 du pont 208. Par rapport au mode de réalisation illustré en figure 7, cette variante est plus encombrante.

Dans le mode de réalisation de la figure 7, le dispositif REFGEN comprend le circuit 222 de la figure 4.

Dans une variante de réalisation, le circuit 222 est omis.

Le fonctionnement du dispositif REFGEN de la figure 7 est à la portée de la personne du métier à partir de la description fonctionnelle faite précédemment des dispositifs REFGEN des figures 5 et 6.

Le dispositif REFGEN décrit en relation avec la figure 7 présente l'avantage de pouvoir être mis en œuvre avec des transistors MOS similaires à ceux du dispositif IP, c'est-à-dire des transistors MOS ayant une tenue en tension Vmax. En outre, les circuits 2000 peuvent alors eux aussi être mis en œuvre avec des transistors MOS ayant une tenue en tension Vmax.

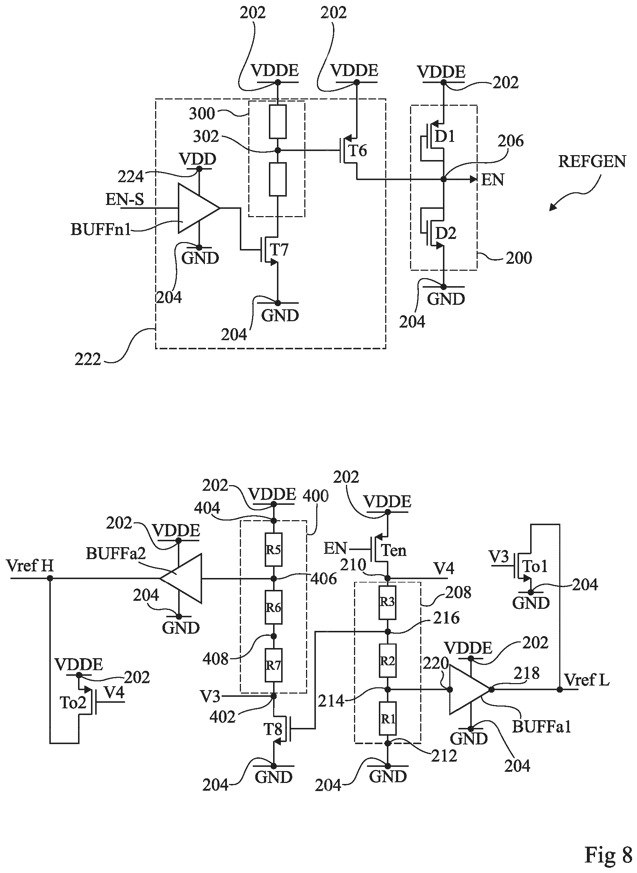

La figure 8 représente, sous la forme d'un circuit, une variante de réalisation du circuit REFGEN de la figure 6. Par rapport au circuit REFGEN de la figure 6 qui est configuré pour fournir la tension VrefL, le circuit REFGEN de la figure 8 est configuré pour générer la tension VrefL et la tension VrefH.

Selon un mode de réalisation, ce dispositif REFGEN fournit la tension VrefH à chaque circuit 2000 précédemment décrit et fait partie du dispositif 3000. En outre, le dispositif REFGEN peut être utilisé pour fournir la tension VrefH aux circuits 2000 décrits précédemment qu'il soit ou non utilisé pour fournir la tension VrefH au circuit IP.

Le dispositif REFGEN de la figure 8 comprend de nombreux éléments en commun avec celui de la figure 6, et seules les différences entre ces deux dispositifs sont ici mises en exergue. En particulier, sauf indication contraire, tous ce qui a été indiqué pour le dispositif REFGEN décrit en relation avec la figure 6 s'applique au dispositif REFGEN de la figure 8. En outre, comme le dispositif REFGEN de la figure 8 comprend des éléments décrits en relation avec le dispositif REFGEN de la figure 7, pour ces éléments, seules les différences entre la figure 7 et la figure 8 sont mises en exergue.

Par rapport au dispositif REFGEN de la figure 6, le dispositif REFGEN de la figure 8 comprend en outre, comme le dispositif REFGEN de la figure 7, le pont diviseur de tension résistif 400 et un transistor MOS T8 en série entre les noeuds 202 et 204.

La source du transistor T8 est connectée à celui des noeuds 202 et 204 auquel n'est pas connectée la source du transistor Ten, c'est-à-dire au noeud 204 dans le mode de réalisation de la figure 8. Dans le mode de réalisation de la figure 8, le transistor T8 est à canal N.

Le transistor T8 est configuré pour être passant, respectivement bloqué, lorsque le transistor Ten est passant, respectivement bloqué. Dans le mode de réalisation de la figure 8, le transistor T8 a sa grille connectée à un noeud intermédiaire du pont 208, par exemple au noeud 216.

Le pont diviseur 400 a son extrémité 404 connectée au noeud 202 dans le mode de réalisation de la figure 8.

Par rapport au dispositif REFGEN de la figure 6, le dispositif REFGEN de la figure 8 comprend, comme le circuit REFGEN de la figure 7, le circuit tampon BUFFa2. L'entrée 412 du circuit BUFFa2 est connectée à un noeud intermédiaire du pont 400, par exemple au noeud 406. Dans le mode de réalisation de la figure 8, la sortie 410 du circuit BUFFa2 fournit la tension VrefH.

Le dispositif REFGEN de la figure 8 comprend en outre, comme le dispositif REFGEN de la figure 7, un transistor MOS To2. La source du transistor To2 est connectée au noeud 202 dans le mode de réalisation de la figure 8 où le circuit BUFFa2 est configuré pour fournir la tension VrefH. Dit autrement, la source du transistor To2 et la source du transistor To1 sont connectées à des noeuds respectifs différents parmi les noeuds 202 et 204. Dans le mode de réalisation de la figure 8, le transistor To2 est à canal P.

Plus particulièrement, dans le mode de réalisation de la figure 8, le transistor To2 est configuré pour que son état passant ou bloqué soit déterminé par une valeur de tension V4 sur un noeud du pont diviseur 208, par exemple sur le noeud 210 du pont diviseur 300, et le transistor To1 est configuré pour que son état passant ou bloqué soit déterminé par une valeur de tension V3 sur un noeud du pont diviseur 400, par exemple sur le noeud 402 du pont 400. Le transistor To1 a sa grille couplée, de préférence connectée, au noeud 402, le transistor To2 ayant sa grille couplée, de préférence connectée, au noeud 210.

Dans une variante de réalisation (non illustrée) le dispositif REFGEN comprend un transistor MOS et un élément résistif en série entre les noeuds 202 et 204, identiques au transistor T5 et à l'élément R4 de la figure 3, et connectés entre eux, au pont 208 et au transistor To1 de la même façon que le transistor T5 et l'élément R4 en figure 6. Le transistor To1 n'est alors pas commandé par la tension V3 du pont 400. Par rapport au mode de réalisation illustré en figure 8, cette variante est plus encombrante.

Dans une autre variante de réalisation, pouvant être combinée avec la variante de réalisation ci-dessus, le dispositif REFGEN comprend un transistor MOS et un élément résistif en série entre les noeuds 202 et 204, identiques au transistor T5 et à l'élément R4 de la figure 5, et connectés entre eux, au pont 208 et au transistor To1 de la même façon que le transistor T5 et l'élément R4 en figure 5. Le transistor To2 n'est alors pas commandé par la tension V4 du pont 208. Par rapport au mode de réalisation illustré en figure 8, cette variante est plus encombrante.

Dans le mode de réalisation de la figure 8, le dispositif REFGEN comprend le circuit 222 de la figure 6.

Dans une variante de réalisation, le circuit 222 est omis.

Le fonctionnement du dispositif REFGEN de la figure 8 est à la portée de la personne du métier à partir de la description fonctionnelle faite précédemment des dispositifs REFGEN des figures 5 et 6.

Le dispositif REFGEN décrit en relation avec la figure 8 présente l'avantage de pouvoir être mis en œuvre avec des transistors MOS similaires à ceux du dispositif IP, c'est-à-dire des transistors MOS ayant une tenue en tension Vmax, sauf en ce qui concerne le transistor T7 qui est dimensionné pour pouvoir tenir la tension VDDE sur son drain. Les circuits 2000 peuvent alors eux aussi être mis en œuvre avec des transistors MOS ayant une tenue en tension Vmax.

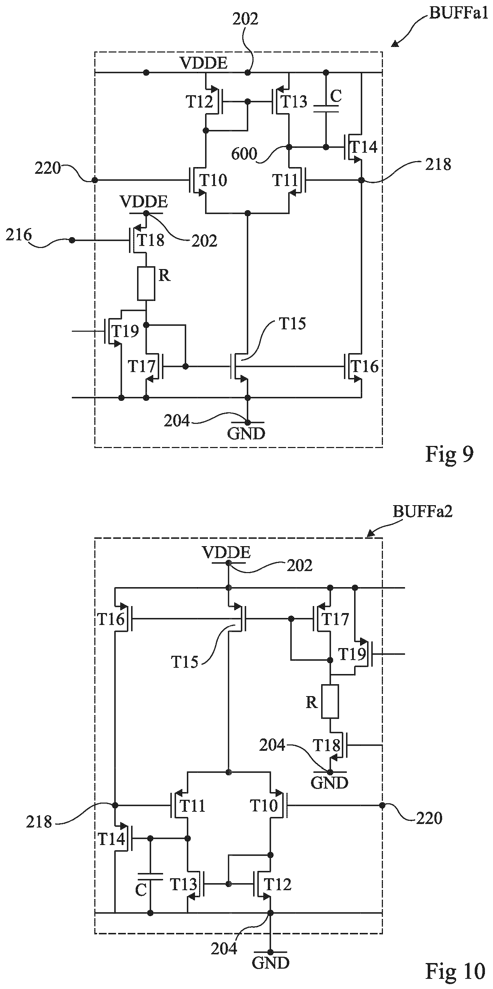

La figure 9 représente, sous la forme d'un circuit, un exemple de mode de réalisation d'un circuit tampon analogique configuré pour fournir la tension VrefH. Dans cet exemple, le circuit tampon décrit est le circuit BUFFa1 mis en œuvre dans le circuit REFGEN de la figure 7.

Le circuit BUFFa1 comprend une paire différentielle comprenant deux transistors MOS T10 et T11. Comme le circuit BUFFa1 fournit la tension VrefH, les transistors T10 et T11 sont de préférence à canal N.

Le transistor T10 a sa grille connectée à l'entrée 220 du circuit BUFFa1, et reçoit donc, dans cet exemple, la tension présente sur le noeud 214 du pont 208 (figure 7). Le transistor T11 a sa grille connectée à la sortie 218 du circuit BUFFa1, et reçoit donc la tension VrefH.

Le circuit BUFFa1 comprend en outre deux transistors MOS T12 et T13 montés en miroir de courant l'un de l'autre, et configuré pour polariser les transistors respectifs T10 et T11 de la paire différentielle. Comme le circuit BUFFa1 fournit la tension VrefH, les transistors T12 et T13 sont de préférence à canal P. Par exemple, les transistors T12 et T13 ont leurs sources connectées au noeud 202 et leurs grilles connectées l'une à l'autre, la grille du transistor T12 étant en outre connectée au drain de ce transistor T12. Par exemple, le drain du transistor T12, respectivement T13, est connecté au drain du transistor T10, respectivement T11.

Le circuit BUFFa1 comprend en outre un transistor MOS T14 ayant sa grille connectée à un noeud 600 de connexion du transistor T13 au transistor T11, et sa source connectée à la sortie 218 du circuit. Comme le circuit BUFFa1 fournit la tension VrefH, le transistor T14 est, de préférence, à canal N et a son drain connecté au noeud 202.

De préférence, un élément capacitif C est connecté entre la grille et la source du transistor T14 pour améliorer la stabilité du circuit BUFFa1.

Le circuit BUFFa1 comprend en outre un transistor MOS T15 couplant la paire différentielle (transistors T10 et T11) à celui des noeuds 202 et 204 auquel ne sont pas connectés les transistors T12 et T13, et un transistor MOS T16 couplant la sortie 218 à celui des noeuds 202 et 204 auquel n'est pas connecté le transistor T14. Dans l'exemple de la figure 9, comme les transistors T12 et T13 sont connectés au noeud 202, le transistor T15 couple donc la paire différentielle au noeud 204, et, en outre, comme le transistor T14 est connecté au noeud 202, le transistor T16 couple donc la sortie 218 au noeud 204. Dans cet exemple, les transistors T15 et T16 sont donc à canal N. Par exemple, les transistors T15 et T16 ont leurs sources connectées au noeud 204, le transistor T15 a son drain couplé, de préférence connecté, aux sources des transistors T10 et T11 de la paire différentielle, et le transistor T16 a son drain couplé, de préférence connecté, à la sortie 218.

Le circuit BUFFa1 comprend en outre un transistor MOS T17 à canal du même type que celui des canaux des transistors T15 et T16, à savoir à canal N dans cet exemple. Ce transistor T17 a sa source connectée au même noeud, 204 dans cet exemple, que le noeud auquel sont connectées les sources des transistors T15 et T16. Les transistors T15 et T16 sont montés en miroir de courant avec le transistor T17. Par exemple, les grilles des transistors T15 et T16 sont connectées chacune à la grille du transistor T17, la grille du transistor T17 étant en outre connectée au drain du transistor T17.

Selon un mode de réalisation, le transistor T17 est avantageusement polarisé à partir d'un noeud intermédiaire du pont diviseur résistif auquel est connecté le circuit BUFFa1, à savoir à partir d'un noeud intermédiaire du pont 208 dans cet exemple, par exemple à partir du noeud 216 du pont 208 (figure 7).

Par exemple, le circuit BUFFa1 comprend un transistor MOS T18 à canal du type opposé à celui du canal du transistor T17, et ayant sa source connectée à celui des noeuds 202 et 204 auquel n'est pas connecté le transistor T17. Ainsi, dans cet exemple, le transistor T18 est à canal P et a sa source connectée au noeud 202. De plus, la grille du transistor T18 est connectée au noeud intermédiaire 216 du pont 208 à partir duquel est polarisé le transistor T17. Une résistance R couple les drains des transistors T17 et T18 entre eux.

Dans une variante de réalisation, le transistor T17 peut être polarisé autrement qu'à partir d'un noeud du pont diviseur résistif auquel est connecté l'entrée 220 du circuit BUFFa1.

Selon un mode de réalisation, pour limiter la consommation du circuit BUFFa1 lorsque le transistor Ten est à l'état bloqué (figure 7), le circuit BUFFa1 comprend un transistor MOS T19 à canal du même type que celui du transistor T17, à savoir à canal N dans cet exemple. Le transistor T19 est configuré pour court-circuiter le transistor T17 lorsque le transistor Ten (figure 7) est bloqué. Par exemple, le transistor T19 a sa source, respectivement son drain, connectée à la source, respectivement au drain, du transistor T17. A titre d'exemple, pour que le transistor T19 soit passant lorsque le transistor Ten est bloqué, la grille du transistor T19 est couplée, de préférence connectée, au drain du transistor qui est en série avec le pont diviseur résistif auquel est connectée l'entrée 220 du circuit BUFFa1, c'est-à-dire au drain du transistor Ten dans cet exemple.

Bien que l'on ait décrit ci-dessus un exemple de mode de réalisation du circuit BUFFa1 du dispositif REFGEN de la figure 7, le circuit BUFFa2 de la figure 8 peut être mis en œuvre par le circuit décrit en relation avec la figure 9. A titre d'exemple, dans ce cas, la grille du transistor T10 est connectée au noeud 406 du pont 400, la grille du transistor T18 est connectée à un noeud du pont 400, par exemple au noeud 408, et la grille du transistor T19 est connectée au drain du transistor T8.

La figure 10 représente, sous la forme d'un circuit, un exemple d'un mode de réalisation d'un circuit tampon analogique configuré pour fournir la tension VrefL. Dans cet exemple, le circuit tampon décrit est le circuit BUFFa2 mis en œuvre dans le circuit REFGEN de la figure 7.

Le circuit BUFFa2 de la figure 10 est similaire au circuit BUFFa1 de la figure 9 et comprend de nombreux éléments en commun avec ce dernier, seules les différences entre ces deux dispositifs étant ici mises en exergue.

En particulier, comme le circuit BUFFa2 fournit la tension VrefL, les transistors T10 et T11 du circuit BUFFa2 sont de préférence à canal P.

Le transistor T10 a ici sa grille connectée à l'entrée 220 du circuit BUFFa2, et reçoit donc, dans cet exemple, la tension présente sur le noeud 406 du pont 400 (figure 7). En outre, le transistor T11 a ici sa grille connectée à la sortie 218 du circuit BUFFa2, et reçoit donc la tension VrefL.

Comme le circuit BUFFa2 fournit la tension VrefL, les transistors T12 et T13 montés en miroir de courant l'un de l'autre pour polariser les transistors respectifs T10 et T11 de la paire différentielle sont de préférence à canal N. Par exemple, les transistors T12 et T13 ont ici leurs sources connectées au noeud 204 et leurs grilles connectées l'une à l'autre, la grille du transistor T12 étant en outre connectée au drain de ce transistor T12. Par exemple, le drain du transistor T12, respectivement T13, est connecté au drain du transistor T10, respectivement T11.

Comme le circuit BUFFa2 fournit la tension VrefL, le transistor T14 ayant sa grille connectée au noeud 600 et sa source connectée à la sortie 218 du circuit BUFFa2 est, de préférence, à canal P et a son drain connecté au noeud 202.

De préférence, le circuit BUFFa2 comprend l'élément capacitif C connecté entre la grille et la source du transistor T14 pour améliorer sa stabilité.

Dans ce mode de réalisation, les transistors T12 et T13 étant connectées au noeud 204, les transistors T15 et T16 sont connectés au noeud 202. Le transistor T15 couple donc la paire différentielle au noeud 202, et, en outre, le transistor T16 couple donc la sortie 218 au noeud 202. Dans cet exemple, les transistors T15 et T16 sont donc à canal P. Par exemple, les transistors T15 et T16 ont leurs sources connectées au noeud 202, le transistor T15 a son drain couplé, de préférence connecté, aux sources des transistors T10 et T11, et le transistor T16 a son drain couplé, de préférence connecté, à la sortie 218.

Le transistor T17 à canal du même type que celui des canaux des transistors T15 et T16 est donc à canal P dans le circuit BUFFa2, et a sa source connectée au même noeud, 202 dans cet exemple, que le noeud auquel sont connectées les sources des transistors T15 et T16. Les transistors T15 et T16 sont montés en miroir de courant avec le transistor T17.

Selon un mode de réalisation, le transistor T17 est avantageusement polarisé à partir d'un noeud intermédiaire du pont diviseur résistif auquel est connecté le circuit BUFFa2, à savoir à partir d'un noeud intermédiaire du pont 400 dans cet exemple, par exemple à partir du noeud 406 du pont 400 (figure 7).

Par exemple, le circuit BUFFa2 comprend le transistor MOS T18 à canal du type opposé à celui du canal du transistor T17, et ayant sa source connectée à celui des noeuds 202 et 204 auquel n'est pas connecté le transistor T17. Ainsi, dans cet exemple, le transistor T18 est à canal N et a sa source connectée au noeud 204. De plus, la grille du transistor T18 est connectée au noeud intermédiaire 406 du pont 400 à partir duquel est polarisé le transistor T17. La résistance R couple les drains des transistors T17 et T18 entre eux.

Dans une variante de réalisation, le transistor T17 peut être polarisé autrement qu'à partir d'un noeud du pont diviseur résistif auquel est connecté l'entrée 220 du circuit BUFFa2.

Selon un mode de réalisation, pour limiter la consommation du circuit BUFFa2 lorsque le transistor Ten est à l'état bloqué (figure 7), le circuit BUFFa2 comprend un transistor MOS T19 à canal du même type que celui du transistor T17, à savoir à canal P dans cet exemple. Le transistor T19 est configuré pour court-circuiter le transistor T17 lorsque le transistor Ten (figure 7) est bloqué. Par exemple, le transistor T19 a sa source, respectivement son drain, connectée à la source, respectivement au drain, du transistor T17. A titre d'exemple, pour que le transistor T19 soit passant lorsque le transistor Ten est bloqué, la grille du transistor T19 est couplée, de préférence connectée, au drain du transistor qui est en série avec le pont diviseur résistif auquel est connectée l'entrée 220 du circuit BUFFa2, c'est-à-dire au drain du transistor T8 dans cet exemple.

Bien que l'on ait décrit ci-dessus un exemple de mode de réalisation du circuit BUFFa2 du dispositif REFGEN de la figure 7, le circuit BUFFa1 de la figure 8 peut être mis en œuvre par le circuit décrit en relation avec la figure 10. A titre d'exemple, dans ce cas, la grille du transistor T10 du circuit de la figure 10 est connectée au noeud 214 du pont 208, la grille du transistor T18 est connectée à un noeud du pont 208, par exemple au noeud 216, et la grille du transistor T19 est connectée au drain du transistor Ten.

Dans les modes de réalisation et variantes décrits précédemment en relation avec les figures 4 à 10, chacune des tensions VrefH et VrefL est générée à partir de la tension VDDE. Ainsi, chacune des tensions VrefH et VrefL suit les variations de la tension VDDE, et, en particulier, les surtensions ou les sous-tensions de la tension VDDE. Cela permet de garder les tensions aux bornes des transistors cascodes T2 et T3 des structures 100 et 102 à des valeurs inférieures à la limite de tenue en tension Vmax de ces transistors. En outre, comme chacune des tensions VrefH et VrefL suit les variations de la tension VDDE et n'est pas générée à partir de la tension VDD, il n'y a plus de contrainte sur l'ordre dans lequel doivent être fournies les tensions d'alimentation VDDE et VDD.

Dans les modes de réalisation et variantes décrits précédemment en relation avec les figures 4 à 10, lorsque le transistor Ten est passant, chacune des tensions VrefH et VrefL est générée à partir de la tension VDDE par un pont diviseur de tension résistif 208 ou 400 correspondant. Ainsi, la dépendance de la valeur courante de chacune des tensions VrefL et VrefH à la température est réduite ou supprimée. En outre, le rapport entre la valeur courante de la tension VrefH, respectivement VrefL, et celle de la tension VDDE peut être aisément choisit en adaptant les valeurs d'un ou plusieurs des éléments résistifs du pont 208 ou 400 correspondant.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif comprenant :
- au moins un circuit (2000), ledit au moins un circuit (2000) comprenant :
un premier noeud (2002) configuré pour recevoir un potentiel de référence (GND) ;
un deuxième noeud (2004) configuré pour recevoir une première tension continue (V1), la première tension continue étant une tension d'alimentation (VDDE, VDD) ;
un troisième noeud (2006) configuré pour recevoir une deuxième tension continue (V2) ;
un premier transistor NMOS (MN1) ayant sa grille connectée au deuxième noeud ;
un deuxième transistor NMOS (MN2) ayant son drain connecté à la source du premier transistor (MN1) et sa source connectée au deuxième noeud ;
un troisième transistor NMOS (MN3) ayant sa grille connectée au deuxième noeud et sa source connectée au premier noeud ;
un quatrième transistor PMOS (MP3) ayant son drain connecté au drain du troisième transistor (MN3) et à la grille du deuxième transistor (MN2) et sa grille connectée à la source du premier transistor (MN1) ;
un premier élément résistif (2008) connecté entre le drain du premier transistor (MN1) et le troisième noeud ;
un deuxième élément résistif (2010) connecté entre la source du quatrième transistor (MP3) et le troisième noeud ; et
un premier inverseur CMOS (INV3) configuré pour être alimenté par la deuxième tension (V2), une entrée du premier inverseur étant connectée au drain du troisième transistor (MP3) et une sortie du premier inverseur étant configurée pour fournir un signal de réinitialisation (POR2000), et
- un circuit de génération de tension configuré pour fournir la deuxième tension continue (V2) à une valeur non nulle avant une mise sous tension et une montée en puissance de la première tension (V1), la valeur non nulle étant adaptée à permettre une commutation à l'état passant du quatrième transistor (MP3) dudit au moins un circuit dès la mise sous tension de la première tension (V1).

2. Dispositif selon la revendication 1, dans lequel chacun des premier et deuxième éléments résistifs (2008, 2010) dudit au moins un circuit (2000) est mis en œuvre par un transistor PMOS (MP1, MP2) ayant sa grille connectée au premier noeud et sa source connectée au troisième noeud.

3. Dispositif selon la revendication 1 ou 2, dans lequel ledit au moins un circuit (2000) comprend en outre un élément capacitif (Cc) connecté entre la grille et la source du premier transistor (MN1).

4. Dispositif selon l'une quelconque des revendications 1 à 3, dans lequel ledit au moins un circuit (2000) comprend en outre un deuxième inverseur CMOS (INV4) configuré pour être alimenté par la deuxième tension (V2), une entrée du deuxième inverseur étant connectée à la sortie du premier inverseur (INV3), et une sortie du deuxième inverseur étant configurée pour fournir un signal (nPOR2000) complémentaire du signal de réinitialisation (POR2000).

5. Dispositif selon l'une quelconque des revendications 1 à 4, dans lequel les premier et deuxième éléments résistifs (2008, 2010) et les premier et quatrième transistors (MN1, MP3) dudit au moins un circuit (2000) sont dimensionnés de sorte que le quatrième transistor (MP3) soit bloqué quand le premier transistor est passant (MN1).

6. Dispositif selon l'une quelconque des revendications 1 à 5, dans lequel la deuxième tension (V2) est aussi une tension d'alimentation (VDDE, VDD).

7. Dispositif selon l'une quelconque des revendication 1 à 6, dans lequel :
ledit au moins un circuit (2000) comprend au moins deux circuits (2000) ;
le dispositif comprend une porte logique CMOS (3002) configurée pour mettre en œuvre une fonction logique booléenne ET entre les signaux de réinitialisation (POR2000) fournis par lesdits au moins deux circuits,
dans lequel :
les premiers noeuds (2002) desdits au moins deux circuits sont configurés pour recevoir le même potentiel de référence (GND) ;
les troisièmes noeuds (2006) desdits au moins deux circuits sont configurés pour recevoir la deuxième tension fournie par le circuit de génération de tension, ladite deuxième tension étant une tension de référence (VrefH) ; et
les deuxièmes noeuds (2004) desdits au moins deux circuits sont configurés chacun pour recevoir une première tension continue d'alimentation (VDDE, VDD) différente des premières tensions reçues par les deuxièmes noeuds des autres circuits.

8. Dispositif selon la revendication 7, dans lequel la porte logique CMOS (3002) est configurée pour être alimentée par la deuxième tension (VrefH) fournie par le circuit de génération de tension.

9. Dispositif selon la revendication 7 ou 8, dans lequel le circuit de génération de tension est configuré pour fournir la deuxième tension continue de référence à sa valeur nominale avant la mise sous tension et la montée en puissance de chacune des premières tensions (VDDE, VDD).

10. Dispositif selon la revendication 7 ou 8, dans lequel le circuit (REFGEN) de génération de la deuxième tension de référence (VrefH) comprend :
un premier pont diviseur de tension (200) connecté entre un premier noeud d'alimentation (202) configuré pour recevoir l'une des premières tensions continues d'alimentation (VDDE) et un deuxième noeud d'alimentation (204) configuré pour recevoir le potentiel de référence (GND) ;
un premier transistor MOS (Ten) et un deuxième pont diviseur de tension résistif (208) connectés en série entre les premier et deuxième noeuds d'alimentation (202, 204), le premier transistor ayant sa grille connectée à un noeud intermédiaire (206) du premier pont et sa source connectée au deuxième noeud d'alimentation (204) ;
un premier circuit tampon (BUFFa1) configuré pour être alimenté par ladite l'une des premières tensions continues d'alimentation (VDDE) et comprenant une entrée (220) connectée à un premier noeud intermédiaire (214) du deuxième pont et une sortie (218) configurée pour fournir la deuxième tension de référence (VrefH) ; et
un deuxième transistor MOS (To1) ayant son drain connecté à la sortie du premier circuit tampon et sa source connectée au premier noeud d'alimentation (202),
dans lequel le premier pont (200) est configuré pour que le premier transistor (Ten) soit bloqué lorsque ladite l'une des premières tensions continues d'alimentation (VDDE) est à une valeur inférieure à un premier seuil lui-même inférieur à une limite de tenue en tension des transistors, et
dans lequel le deuxième transistor (To1) est configuré pour être à l'état passant si le premier transistor (Ten) est à l'état bloqué et inversement.

11. Dispositif selon la revendication 7 ou 8 dans lequel le circuit (REFGEN) de génération de la deuxième tension de référence (VrefH) comprend :
un premier pont diviseur de tension (200) connecté entre un premier noeud d'alimentation (202) configuré pour recevoir l'une des premières tensions continues d'alimentation (VDDE) et un deuxième noeud d'alimentation (204) configuré pour recevoir le potentiel de référence (GND) ;
un premier transistor MOS (Ten) et un deuxième pont diviseur de tension résistif (208) connectés en série entre les premier et deuxième noeuds d'alimentation (202, 204), le premier transistor ayant sa grille connectée à un noeud intermédiaire (206) du premier pont et sa source connectée au premier noeud d'alimentation (202) ;
un deuxième transistor MOS (T8) et un troisième pont diviseur de tension résistif (400) connectés en série entre les premier et deuxième noeuds d'alimentation (202, 204), la source du deuxième transistor MOS (T8) étant connectée au deuxième noeud d'alimentation (202, 204) ;
un circuit tampon (BUFFa2) configuré pour être alimenté par ladite l'une des premières tensions continues d'alimentation (VDDE) et comprenant une entrée (220) connectée à un premier noeud intermédiaire (406) du troisième pont (400) et une sortie (218) configurée pour fournir la deuxième tension de référence (VrefH) ; et
un troisième transistor MOS (To2) ayant son drain connecté à la sortie du circuit tampon (BUFFa2) et sa source connectée au premier noeud d'alimentation (202) ;
dans lequel le deuxième transistor (T8) est configuré pour être à l'état bloqué, respectivement passant, quand le premier transistor (Ten) est à l'état bloqué, respectivement passant,
dans lequel le troisième transistor (To2) est configuré pour être à l'état passant si le deuxième transistor (T8) est à l'état bloqué et inversement, et
dans lequel le premier pont (200) est configuré pour que le premier transistor (Ten) soit bloqué lorsque ladite l'une des premières tensions continues d'alimentation (VDDE) est à une valeur inférieure à un premier seuil lui-même inférieur à une limite de tenue en tension des transistors.

## Patentansprüche

1. Vorrichtung, die Folgendes aufweist:
- wenigstens einen Schaltkreis (2000), wobei der wenigstens eine Schaltkreis (2000) Folgendes aufweist:
einen ersten Knoten (2002), der eingerichtet ist zum Empfangen eines Referenzpotentials (GND);
einen zweiten Knoten (2004), der eingerichtet ist zum Empfangen einer ersten Gleichspannung (V1), wobei die erste Gleichspannung eine Versorgungsspannung (VDDE, VDD) ist;
einen dritten Knoten (2006), der eingerichtet ist zum Empfangen einer zweiten Gleichspannung (V2);
einen ersten NMOS-Transistor (MN1), der sein Gate mit dem zweiten Knoten verbunden hat;
einen zweiten NMOS-Transistor (MN2), der seinen Drain mit der Source des ersten Transistors (MN1) verbunden hat und seine Source mit dem zweiten Knoten verbunden hat;
einen dritten NMOS-Transistor (MN3), der sein Gate mit dem zweiten Knoten verbunden hat und seine Source mit dem ersten Knoten verbunden hat;
einen vierten PMOS-Transistor (MP3), der seinen Drain mit dem Drain des dritten Transistors (MN3) und mit dem Gate des zweiten Transistors (MN2) verbunden hat und sein Gate mit der Source des ersten Transistors (MN1) verbunden hat;
ein erstes resistives Element (2008), das zwischen dem Drain des ersten Transistors (MN1) und dem dritten Knoten verbunden ist;
ein zweites resistives Element (2010), das zwischen der Source des vierten Transistors (MP3) und dem dritten Knoten verbunden ist; und
einen ersten CMOS-Inverter (INV3), der eingerichtet ist zum versorgt werden mit der zweiten Spannung (V2), wobei ein Eingang des ersten Inverters mit dem Drain des dritten Transistors (MP3) verbunden ist und ein Ausgang des ersten Inverters eingerichtet ist zum Liefern eines Rücksetzsignals (POR2000), und
- einen Spannungserzeugungsschaltkreis, der eingerichtet ist zum Liefern der zweiten Gleichspannung (V2) bei einem Wert ungleich Null vor einem Einschalten und einem Hochfahren der ersten Spannung (V1), wobei der Wert ungleich Null angepasst ist zum Ermöglichen eines Umschaltens in den Ein-Zustand des vierten Transistors (MP3) des wenigstens einen Schaltkreises ab dem Einschalten der ersten Spannung (V1).

2. Vorrichtung nach Anspruch 1, wobei jedes der ersten und zweiten resistiven Elemente (2008, 2010) durch einen PMOS-Transistor (MP1, MP2) implementiert ist, der sein Gate mit dem ersten Knoten verbunden hat und seine Source mit dem dritten Knoten verbunden hat.

3. Vorrichtung nach Anspruch 1 oder 2, wobei der wenigstens eine Schaltkreis (2000) ferner ein kapazitives Element (Cc) aufweist, das zwischen dem Gate und der Source des ersten Transistors (MN1) verbunden ist.

4. Vorrichtung nach einem der Ansprüche 1 bis 3, wobei der wenigstens eine Schaltkreis (2000) ferner einen zweiten CMOS-Inverter (INV4) aufweist, der eingerichtet ist zum versorgt werden mit der zweiten Spannung (V2), wobei ein Eingang des zweiten Inverters mit dem Ausgang des ersten Inverters (INV3) verbunden ist, und ein Ausgang des zweiten Inverters eingerichtet ist zum Liefern eines Signals (nPOR2000) komplementär zu dem Rücksetzsignal (POR2000).

5. Vorrichtung nach einem der Ansprüche 1 bis 4, wobei die ersten und zweiten resistiven Elemente (2008, 2010), und die ersten und vierten Transistoren (MN1, MP3) so dimensioniert sind, dass der vierte Transistor (MP3) aus ist, wenn der erste Transistor ein ist (MN1).

6. Vorrichtung nach einem der Ansprüche 1 bis 5, wobei die zweite Spannung (V2) auch eine Versorgungsspannung (VDDE, VDD) ist.

7. Vorrichtung nach einem der Ansprüche 1 bis 6, wobei:
der wenigstens eine Schaltkreis (2000) wenigstens zwei Schaltkreise (2000);
die Vorrichtung ein CMOS-Logikgatter (3002) aufweist, das eingerichtet ist zum Implementieren einer booleschen UND-Logikfunktion zwischen den Rücksetzsignalen (POR2000), die von den wenigstens zwei Schaltkreisen geliefert werden, wobei:
die ersten Knoten (2002) der wenigstens zwei Schaltkreise eingerichtet sind zum Empfangen des gleichen Referenzpotentials (GND);
die dritten Knoten (2006) der wenigstens zwei Schaltkreise eingerichtet sind zum Empfangen der zweiten Spannung, die von dem Spannungserzeugungsschaltkreis geliefert wird, wobei die zweite Spannung eine Referenzspannung (VrefH) ist; und
die zweiten Knoten (2004) der wenigstens zwei Schaltkreise jeweils eingerichtet sind zum Empfangen einer ersten Gleich-Versorgungsspannung (VDDE, VDD), die unterschiedlich von den ersten Spannungen ist, die von den zweiten Knoten der anderen Schaltkreise empfangen werden.

8. Vorrichtung nach Anspruch 7, wobei das CMOS-Logikgatter (3002) eingerichtet ist zum versorgt werden mit der zweiten Spannung (VrefH), die von dem Spannungserzeugungsschaltkreis geliefert wird.

9. Vorrichtung nach Anspruch 7 oder 8, wobei der Spannungserzeugungsschaltkreis eingerichtet ist zum Liefern der zweiten Gleichreferenzspannung bei ihrem Nennwert vor dem Einschalten und dem Hochfahren jeder der ersten Spannungen (VDDE, VDD).

10. Vorrichtung nach Anspruch 7 oder 8, wobei der Schaltkreis (REFGEN) zum Erzeugen der zweiten Referenzspannung (VrefH) Folgendes aufweist:
eine erste Spannungsteilerbrücke (200), die zwischen einem ersten Versorgungsknoten (202) verbunden ist, der eingerichtet ist zum Empfangen einer der ersten Gleich-Versorgungsspannungen (VDDE), und einem zweiten Versorgungsknoten (204), der eingerichtet ist zum Empfangen des Referenzpotentials (GND);
einen ersten MOS-Transistor (Ten) und eine zweite resistive Spannungsteilerbrücke (208), die in Reihe zwischen den ersten und zweiten Versorgungsknoten (202, 204) verbunden sind, wobei der erste Transistor sein Gate mit einem Zwischenknoten (206) der ersten Brücke verbunden hat und seine Source mit dem zweiten Versorgungsknoten (204) verbunden hat;
einen ersten Pufferschaltkreis (BUFFa1), der eingerichtet ist zum versorgt werden mit der einen der ersten Gleich-Versorgungsspannungen (VDDE) und der einen Eingang (220) aufweist, der mit einem ersten Zwischenknoten (214) der zweiten Brücke verbunden ist, und einen Ausgang (218), der eingerichtet ist zum Liefern der zweiten Referenzspannung (VrefH); und
einen zweiten MOS-Transistor (To1), der seinen Drain mit dem Ausgang des ersten Pufferschaltkreises verbunden hat und seine Source mit dem ersten Versorgungsknoten (202) verbunden hat,
wobei die erste Brücke (200) so ausgebildet ist, dass der erste Transistor (Ten) aus ist, wenn die eine der ersten Gleich-Versorgungsspannungen (VDDE) bei einem Wert niedriger als ein erster Schwellenwert ist, der selbst niedriger als eine Durchbruchspannung der Transistoren ist, und wobei der zweite Transistor (To1) eingerichtet ist in dem Ein-Zustand zu sein, wenn der erste Transistor (Ten) aus ist, und umgekehrt.

11. Vorrichtung nach Anspruch 7 oder 8, wobei der Schaltkreis (REFGEN) zum Erzeugen der zweiten Referenzspannung (VrefH) Folgendes aufweist:
eine erste Spannungsteilerbrücke (200), die zwischen einem ersten Versorgungsknoten (202) verbunden ist, der eingerichtet ist zum Empfangen einer der ersten Gleich-Versorgungsspannungen (VDDE), und einem zweiten Versorgungsknoten (204), der eingerichtet ist zum Empfangen des Referenzpotentials (GND);
einen ersten MOS-Transistor (Ten) und eine zweite resistive Spannungsteilerbrücke (208), die in Reihe zwischen den ersten und zweiten Versorgungsknoten (202, 204) verbunden sind, wobei der erste Transistor sein Gate mit einem Zwischenknoten (206) der ersten Brücke verbunden hat und seine Source mit dem ersten Versorgungsknoten (202) verbunden hat;
einen zweiten MOS-Transistor (T8) und eine dritte resistive Spannungsteilerbrücke (400), die in Reihe zwischen den ersten und zweiten Versorgungsknoten (202, 204) verbunden sind, wobei die Source des zweiten MOS-Transistors (T8) mit dem zweiten Versorgungsknoten (202, 204) verbunden ist;
einen Pufferschaltkreis (BUFFa2), der eingerichtet ist zum versorgt werden mit der einen der ersten Gleich-Versorgungsspannungen (VDDE) und der einen Eingang (220) aufweist, der mit einem ersten Zwischenknoten (406) der dritten Brücke (400) verbunden ist, und einen Ausgang (218), der eingerichtet ist zum Liefern der zweiten Referenzspannung (VrefH); und
einen dritten MOS-Transistor (To2), der seinen Drain mit dem Ausgang des Pufferschaltkreises (BUFFa2) verbunden hat und seine Source mit dem ersten Versorgungsknoten (202) verbunden hat; wobei der zweite Transistor (T8) eingerichtet ist in dem Aus- bzw. Ein-Zustand zu sein, wenn der erste Transistor (Ten) in dem Aus- bzw. Ein-Zustand ist, wobei der dritte Transistor (To2) eingerichtet ist in dem Ein-Zustand zu sein, wenn der zweite Transistor (T8) in dem Aus-Zustand ist, und umgekehrt, und wobei die erste Brücke (200) so ausgebildet ist, dass der erste Transistor (Ten) aus ist, wenn die eine der ersten Gleich-Versorgungsspannungen (VDDE) bei einem Wert niedriger als ein erster Schwellenwert ist, der selbst niedriger als eine Durchbruchspannung der Transistoren ist.

## Claims

1. Device comprising:
- at least one circuit (2000), said at least one circuit (2000) comprising:
a first node (2002) configured to receive a reference potential (GND);
a second node (2004) configured to receive a first DC voltage (V1), the first DC voltage being a power supply voltage (VDDE, VDD);
a third node (2006) configured to receive a second DC voltage (V2);
a first NMOS transistor (MN1) having its gate connected to the second node;
a second NMOS transistor (MN2) having its drain connected to the source of the first transistor (MN1) and its source connected to the second node;
a third NMOS transistor (MN3) having its gate connected to the second node and its source connected to the first node;
a fourth PMOS transistor (MP3) having its drain connected to the drain of the third transistor (MN3) and to the gate of the second transistor (MN2) and its gate connected to the source of the first transistor (MN1);
a first resistive element (2008) connected between the drain of the first transistor (MN1) and the third node;
a second resistive element (2010) connected between the source of the fourth transistor (MP3) and the third node; and
a first CMOS inverter (INV3) configured to be powered with the second voltage (V2), an input of the first inverter being connected to the drain of the third transistor (MP3) and an output of the first inverter being configured to deliver a reset signal (POR2000), and
- a voltage generation circuit configured to deliver the second DC voltage (V2) at a non-zero value before a powering on and a ramping up of the first voltage (V1), the non-zero value being adapted to allowing a switching to the on state of the fourth transistor (MP3) of said at least one circuit from the powering on of the first voltage (V1).

2. Device according to claim 1, wherein each of the first and second resistive elements (2008, 2010) is implemented by a PMOS transistor (MP1, MP2) having its gate connected to the first node and its source connected to the third node.

3. Device according to claim 1 or 2, wherein said at least one circuit (2000) further comprises a capacitive element (Cc) connected between the gate and source of the first transistor (MN1).

4. Device according to any of claims 1 to 3, wherein said at least one circuit (2000) further comprises a second CMOS inverter (INV4) configured to be powered with the second voltage (V2), an input of the second inverter being connected to the output of the first inverter (INV3), and an output of the second inverter being configured to deliver a signal (nPOR2000) complementary to the reset signal (POR2000).

5. Device according to any of claims 1 to 4, wherein the first and second resistive elements (2008, 2010), and the first and fourth transistors (MN1, MP3) are sized so that the fourth transistor (MP3) is off when the first transistor is on (MN1).

6. Device according to any of claims 1 to 5, wherein the second voltage (V2) also is a power supply voltage (VDDE, VDD).

7. Device according to any of claims 1 to 6, wherein:
said at least one circuit (2000) comprises at least two circuits (2000);
the device comprises a CMOS logic gate (3002) configured to implement a Boolean AND logic function between the reset signals (POR2000) delivered by said at least two circuits, wherein:
the first nodes (2002) of said at least two circuits are configured to receive the same reference potential (GND);
the third nodes (2006) of said at least two circuits are configured to receive the second voltage delivered by the voltage generation circuit, said second voltage being a reference voltage (VrefH); and
the second nodes (2004) of said at least two circuits are each configured to receive a first DC power supply voltage (VDDE, VDD) different from the first voltages received by the second nodes of the other circuits.

8. Device according to claim 7, wherein the CMOS logic gate (3002) is configured to be powered with the second voltage (VrefH) delivered by the voltage generation circuit.

9. Device according to claim 7 or 8, wherein the voltage generation circuit is configured to deliver the second DC reference voltage at its nominal value prior to the powering on and the ramping up of each of the first voltages (VDDE, VDD) .

10. Device according to claim 7 or 8, wherein the circuit (REFGEN) for generating the second reference voltage (VrefH) comprises:
a first voltage dividing bridge (200) connected between a first power supply node (202) configured to receive one of the first DC power supply voltages (VDDE) and a second power supply node (204) configured to receive the reference potential (GND);
a first MOS transistor (Ten) and a second resistive voltage dividing bridge (208) connected in series between the first and second power supply nodes (202, 204), the first transistor having its gate connected to an intermediate node (206) of the first bridge and its source connected to the second power supply node (204);
a first buffer circuit (BUFFa1) configured to be powered with said one of the first DC power supply voltages (VDDE) and comprising an input (220) connected to a first intermediate node (214) of the second bridge and an output (218) configured to deliver the second reference voltage (VrefH); and
a second MOS transistor (To1) having its drain connected to the output of the first buffer circuit and its source connected to the first power supply node (202),
wherein the first bridge (200) is configured so that the first transistor (Ten) is off when said one of the first DC power supply voltages (VDDE) is at a value lower than a first threshold, itself lower than a breakdown voltage of the transistors, and
wherein the second transistor (To1) is configured to be in the on state if the first transistor (Ten) is off, and conversely.

11. Device according to claim 7 or 8, wherein the circuit (REFGEN) for generating the second reference voltage (VrefH) comprises:
a first voltage dividing bridge (200) connected between a first power supply node (202) configured to receive one of the first DC power supply voltages (VDDE) and a second power supply node (204) configured to receive the reference potential (GND);
a first MOS transistor (Ten) and a second resistive voltage dividing bridge (208) connected in series between the first and second power supply nodes (202, 204), the first transistor having its gate connected to an intermediate node (206) of the first bridge and its source connected to the first power supply node (202);
a second MOS transistor (T8) and a third resistive voltage dividing bridge (400) connected in series between the first and second power supply nodes (202, 204), the source of the second MOS transistor (T8) being connected to the second power supply node (202, 204);
a buffer circuit (BUFFa2) configured to be powered with said one of the first DC power supply voltages (VDDE) and comprising an input (220) connected to a first intermediate node (406) of the third bridge (400) and an output (218) configured to deliver the second reference voltage (VrefH); and
a third MOS transistor (To2) having its drain connected to the output of the buffer circuit (BUFFa2) and its source connected to the first power supply node (202);
wherein the second transistor (T8) is configured to be in the off, respectively on, state when the first transistor (Ten) is in the off, respectively on, state,
wherein the third transistor (To2) is configured to be in the on state if the second transistor (T8) is in the off state, and conversely, and
wherein the first bridge (200) is configured so that the first transistor (Ten) is off when said one of the first DC power supply voltages (VDDE) is at a value lower than a first threshold, itself lower than a breakdown voltage of the transistors.
